# EUROPEAN PATENT APPLICATION

(11) **EP 4 693 291 A1**
(43) Date of publication of application: **11.02.2026**
(21) Application number: 25169985.6
(22) Date of filing: 11.04.2025
(51) Int. Cl.: G11C 7/10, G06F 3/06, G11C 16/32, G06F 13/16, G06F 13/42

(54) **STORAGE DEVICE AND OPERATING METHOD OF STORAGE DEVICE**

(30) Priority: 08.08.2024 KR 20240106186; 28.02.2025 US 202519067259
(71) Applicant: Samsung Electronics Co., Ltd., Suwon-si, Gyeonggi-do 16677 (KR)
(72) Inventor: JEONG, Yong-Taek, Suwon-si, Gyeonggi-do 16677 (KR)
(74) Representative: Kuhnen & Wacker Patent- und Rechtsanwaltsbüro PartG mbB

(57) **Abstract**

There is provided a storage device which includes a plurality of nonvolatile memory devices, and a memory controller connected in common to the plurality of nonvolatile memory devices through first signal lines and connected in common to the plurality of nonvolatile memory devices through second signal lines. Each of the plurality of nonvolatile memory devices receives a command and an address through the first signal lines and communicates data bits with the memory controller through the second signal lines. While the command and the address are not received through the first signal lines, the plurality of nonvolatile memory devices exchange information through the first signal lines without control of the memory controller.

## Description

### BACKGROUND

The disclosure relates to a semiconductor device, and more particularly, to a storage device and an operating method of the storage device.

A storage device may include a memory controller and a plurality of nonvolatile memory devices. The plurality of nonvolatile memory devices which are connected to the memory controller through common signal lines may correspond to one channel. The plurality of nonvolatile memory devices may communicate with the memory controller based on a communication standard.

The plurality of nonvolatile memory devices may share information with each other, which may help the management of the plurality of nonvolatile memory devices. On the other hand, when the plurality of nonvolatile memory devices share information with each other, the control of the plurality of nonvolatile memory devices may be hindered, As such, the throughput of a storage device may decrease, resulting in an undesired and/or suboptimal operation of the storage device. Also, the plurality of nonvolatile memory devices sharing information with each other may not satisfy the communication standard, resulting in an undesired technology which does not satisfy the communication standard.

### SUMMARY

Aspects of the disclosure provide a device and a method for allowing nonvolatile memory devices to share information with each other without hindering an operation in which a memory controller controls the nonvolatile memory devices.

According to an aspect of the disclosure, there is provided a storage device including: a plurality of nonvolatile memory devices; and a memory controller connected in common to the plurality of nonvolatile memory devices through first signal lines and connected in common to the plurality of nonvolatile memory devices through second signal lines, wherein each of the plurality of nonvolatile memory devices is configured to: based on receiving a command and an address through the first signal lines, communicate data bits with the memory controller through the second signal lines corresponding to the command and the address received through the first signal lines, based on receiving no commands through the first signal lines, exchange information through the first signal lines with one or more other nonvolatile memory devices, among the plurality of nonvolatile memory devices.

According to another aspect of the disclosure, there is provided an operating method of a storage device which includes a plurality of nonvolatile memory devices and a memory controller, the method including: setting, by the memory controller, the plurality of nonvolatile memory devices to operate in a first mode; transmitting, by the memory controller, a first clock signal and a command and an address, which are synchronized with the first clock signal, to the plurality of nonvolatile memory devices through first signal lines; communicating, at the plurality of nonvolatile memory devices, a data strobe signal and data bits synchronized with the data strobe signal with the memory controller based on the command and address; and exchanging, at the plurality of nonvolatile memory devices, information through the first signal lines in synchronization with the data strobe signal without control of the memory controller, while the memory controller does not transmit the first clock signal through the first signal lines, in the first mode.

According to another aspect of the disclosure, there is provided a storage device including: a plurality of first nonvolatile memory devices connected to a first channel; a plurality of second nonvolatile memory devices connected to a second channel; and a memory controller connected to the first channel and the second channel, wherein the memory controller is configured to: set the plurality of first nonvolatile memory devices to operate in one of a first mode and a second mode; and set the plurality of second nonvolatile memory devices to operate in one of the first mode and the second mode independently of the mode set for the plurality of first nonvolatile memory devices, wherein each of the first channel and the second channel includes: first signal lines configured to transfer a command and an address; and second signal lines configured to transfer data bits, wherein, in the first mode, the plurality of first nonvolatile memory devices are configured to exchange information through the first signal lines based on receiving no commands through the first signal lines, and wherein, in the second mode, the plurality of first nonvolatile memory devices are configured to omit the exchange of the information through the first signal lines.

### BRIEF DESCRIPTION OF DRAWING

The above and other objects and features of the disclosure will become apparent by describing in detail embodiments thereof with reference to the accompanying drawings.
FIG. 1 illustrates a storage device according to an embodiment of the disclosure.
FIG. 2 illustrates an example of control logic and a data buffer.
FIG. 3 is flowchart illustrating an operating method of a storage device according to an embodiment of the disclosure.
FIGS. 4A, 4B, 4C, 4D, and 4E illustrate examples in which a storage device operates in an SCA mode with inter-device communication based on a data strobe signal.
FIG. 5 illustrates an example of a request packet and a response packet according to an embodiment of the disclosure.
FIGS. 6A, 6B, 6C, and 6D illustrate an example in which a nonvolatile memory device communicates data bits of data and data bits of a request packet and a response packet in synchronization with a data strobe signal.
FIG. 7 illustrates another example of control logic and a data buffer.
FIGS. 8A and 8B illustrate examples in which a storage device operates in an SCA mode with inter-device communication based on a second clock signal.
FIGS. 9A and 9B illustrate examples which a first nonvolatile memory device, a second nonvolatile memory device, a third nonvolatile memory device, and a fourth nonvolatile memory device communicate a first command address signal and a second command address signal.
FIGS. 10A, 10B, 10C, 10D, and 10E illustrate examples in which a storage device operates in a legacy mode.
FIG. 11 illustrates an example in which a memory controller uses inter-device communication.
FIG. 12 is a flowchart illustrating an operating method of a nonvolatile memory device according to an embodiment of the disclosure.
FIG. 13 illustrates a storage device according to another embodiment of the disclosure.
FIG. 14 is a block diagram illustrating a nonvolatile memory device according to an embodiment of the disclosure.
FIG. 15 is a block diagram illustrating a system according to an embodiment of the disclosure.

### DETAILED DESCRIPTION

Below, embodiments of the disclosure will be described in detail and clearly to such an extent that an ordinary one in the art easily carries out the disclosure.

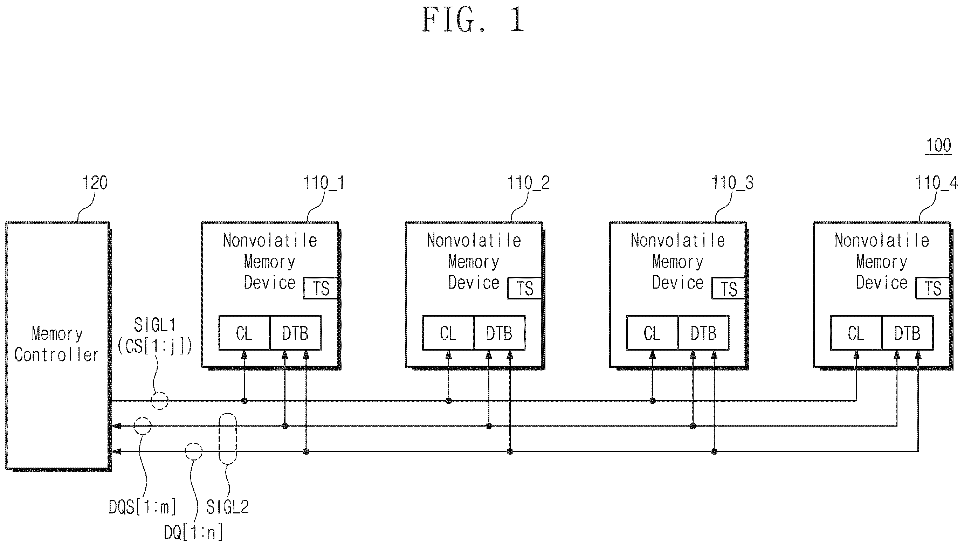

FIG. 1 illustrates a storage device 100 according to an embodiment of the disclosure. Referring to FIG. 1, the storage device 100 may include a first nonvolatile memory device 110_1, a second nonvolatile memory device 110_2, a third nonvolatile memory device 110_3, a fourth nonvolatile memory device 110_4, and a memory controller 120. However, the disclosure is not limited thereto, and as such, according to an embodiment, a number of nonvolatile memory device may be different than four. In another embodiment, the storage device 100 may include one or more other components.

The first nonvolatile memory device 110_1, the second nonvolatile memory device 110_2, the third nonvolatile memory device 110_3, and the fourth nonvolatile memory device 110_4 may be connected to the memory controller 120. For example, the first nonvolatile memory device 110_1, the second nonvolatile memory device 110_2, the third nonvolatile memory device 110_3, and the fourth nonvolatile memory device 110_4 may be connected in common to the memory controller 120 through first signal lines SIGL1 and second signal lines SIGL2. The first nonvolatile memory device 110_1, the second nonvolatile memory device 110_2, the third nonvolatile memory device 110_3, and the fourth nonvolatile memory device 110_4 which are connected in common to the memory controller 120 may form one channel.

The first signal lines SIGL1 may transit or transfer j control signals CS[1:j] (j being a positive integer) to the first nonvolatile memory device 110_1, the second nonvolatile memory device 110_2, the third nonvolatile memory device 110_3, and the fourth nonvolatile memory device 110_4. For example, the first signal lines SIGL1 may transmit or transfer the control signals CS[1:j] in one direction.

The second signal lines SIGL2 may transmit or transfer m data strobe signals DQS[1:m] (m being a positive integer) and n data signals DQ[1:n] (n being a positive integer) between the memory controller 120 and the first nonvolatile memory device 110_1, the second nonvolatile memory device 110_2, the third nonvolatile memory device 110_3, and the fourth nonvolatile memory device 110_4. For example, the second signal lines SIGL2 may transmit or transfer the data strobe signals DQS[1:m] and the data signals DQ[1:n] in both directions.

Each of the first nonvolatile memory device 110_1, the second nonvolatile memory device 110_2, the third nonvolatile memory device 110_3, and the fourth nonvolatile memory device 110_4 may include control logic CL, a data buffer DTB, and a temperature sensor TS.

The control logic CL may receive the control signals CS[1:j] from the memory controller 120 through the first signal lines SIGL1. The control logic CL may control operations of the nonvolatile memory device 110_1, 110_2, 110_3, or 110_4, based on the control signals CS[1:j]. For example, based on the control signals CS[1:j], the control logic CL may control the nonvolatile memory device 110_1, 110_2, 110_3, or 110_4 to perform the write operation, the read operation, or the erase operation.

The data buffer DTB may communicate (or exchange) the data strobe signals DQS[1:m] and the data signals DQ[1:n] with the memory controller 120 through the second signal lines SIGL2.

In a write operation, the data buffer DTB may latch data bits transferred through the data signals DQ[1:n] based on or corresponding to the data strobe signals DQS[1:m]. For example, in the write operation, the data buffer DTB may latch data bits transferred through the data signals DQ[1:n] in synchronization with the data strobe signals DQS[1:m]. The data buffer DTB may transfer the latched data bits to a core circuit of the nonvolatile memory device 110_1, 110_2, 110_3, or 110_4 such that the data bits are written in the nonvolatile memory device 110_1, 110_2, 110_3, or 110_4.

In the read operation, the data buffer DTB may output data bits transferred from the core circuit of the nonvolatile memory device 110_1, 110_2, 110_3, or 110_4 as the data signals DQ[1:n] based on or corresponding to the data strobe signals DQS[1:m]. For example, in the read operation, the data buffer DTB may output data bits transferred from the core circuit of the nonvolatile memory device 110_1, 110_2, 110_3, or 110_4 as the data signals DQ[1:n] in synchronization with the data strobe signals DQS[1:m].

The temperature sensor TS may measure a temperature of the nonvolatile memory device 110_1, 110_2, 110_3, or 110_4. For example, the temperature sensor TS may be provided at a specific position in the nonvolatile memory device 110_1, 110_2, 110_3, or 110_4, for example, a position where the heat generation is the greatest. The temperature sensor TS may measure an ambient temperature, for example, the temperature of the nonvolatile memory device 110_1, 110_2, 110_3, or 110_4 periodically (e.g., based on a first period) and may store (or update) temperature information. The temperature sensor TS may provide the temperature information to the control logic CL periodically (e.g., based on a second period).

According to an embodiment, based on a specific condition being satisfied, the first nonvolatile memory device 110_1, the second nonvolatile memory device 110_2, the third nonvolatile memory device 110_3, and the fourth nonvolatile memory device 110_4 may exchange information with each other without control of the memory controller 120. For example, the first nonvolatile memory device 110_1, the second nonvolatile memory device 110_2, the third nonvolatile memory device 110_3, and the fourth nonvolatile memory device 110_4 may exchange information through the first signal lines SIGL1. In this case, the first signal lines SIGL1 may exchange information in both direction.

The information exchange between two or more of the first nonvolatile memory device 110_1, the second nonvolatile memory device 110_2, the third nonvolatile memory device 110_3, and the fourth nonvolatile memory device 110_4 may include at least one of peak current information, temperature information, and status information.

For example, the peak current information may include, but is not limited to, information about a current peak current amount or information about a peak current amount within a given time window. For example, temperature information may include, but is not limited, temperature information acquired from the temperature sensor TS. For example, the status information may include, but is not limited to, information indicating a status of an operation. For example, the status information may include information indicating whether the write operation, the read operation, or the erase operation is failed or succeeded. According to an embodiment, the storage device may be managed or controlled based on the information exchanged between two or more of the first nonvolatile memory device 110_1, the second nonvolatile memory device 110_2, the third nonvolatile memory device 110_3, and the fourth nonvolatile memory device 110_4.

In an embodiment, an operation in which the first nonvolatile memory device 110_1, the second nonvolatile memory device 110_2, the third nonvolatile memory device 110_3, and the fourth nonvolatile memory device 110_4 exchange information without control of the memory controller 120 may be referred to as inter-device communication or "inter-device comm". In another example, because a plurality of semiconductor dies integrated in one package forms one channel, an operation in which the first nonvolatile memory device 110_1, the second nonvolatile memory device 110_2, the third nonvolatile memory device 110_3, and the fourth nonvolatile memory device 110_4 exchange information without control of the memory controller 120 may be referred to as inter-die communication or "inter-die comm".

In an embodiment, additional signal lines may be provided between the memory controller 120 and the first nonvolatile memory device 110_1, the second nonvolatile memory device 110_2, the third nonvolatile memory device 110_3, and the fourth nonvolatile memory device 110_4. The additional signal lines may include, but is not limited to, chip enable signal lines, ready-busy signal lines For example, the chip enable signal lines may be respectively provided between the memory controller 120 and the first nonvolatile memory device 110_1, the second nonvolatile memory device 110_2, the third nonvolatile memory device 110_3, and the fourth nonvolatile memory device 110_4. The memory controller 120 may select a nonvolatile memory device targeted for access by activating a signal of one of the chip enable signal lines connected to the first nonvolatile memory device 110_1, the second nonvolatile memory device 110_2, the third nonvolatile memory device 110_3, and the fourth nonvolatile memory device 110_4 and deactivating signals of the remaining chip enable signal lines.

For example, the ready-busy signal lines may be respectively provided between the memory controller 120 and the first nonvolatile memory device 110_1, the second nonvolatile memory device 110_2, the third nonvolatile memory device 110_3, and the fourth nonvolatile memory device 110_4. Each of the first nonvolatile memory device 110_1, the second nonvolatile memory device 110_2, the third nonvolatile memory device 110_3, and the fourth nonvolatile memory device 110_4 may notify the memory controller 120 that its own state is a ready state or a busy state, by activating or deactivating a signal of the corresponding ready-busy signal line.

In an embodiment, at least one of the first nonvolatile memory device 110_1, the second nonvolatile memory device 110_2, the third nonvolatile memory device 110_3, and the fourth nonvolatile memory device 110_4 may not include a temperature sensor TS. In this case, temperature information of some nonvolatile memory devices, which include the temperature sensor TS, from among the first nonvolatile memory device 110_1, the second nonvolatile memory device 110_2, the third nonvolatile memory device 110_3, and the fourth nonvolatile memory device 110_4 may be exchanged.

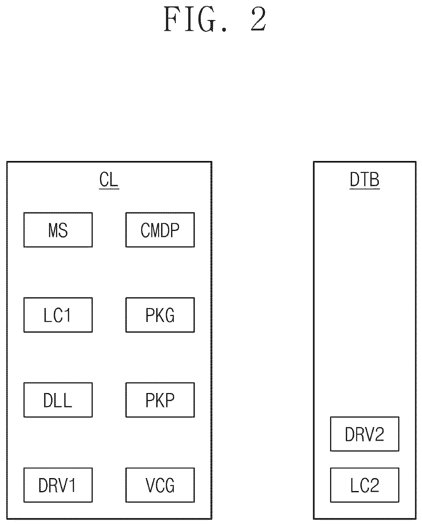

FIG. 2 illustrates an example of the control logic CL and the data buffer DTB. Referring to FIGS. 1 and 2, the control logic CL may include, but is not limited to, mode storage MS, a first latch LC1, a delay locked loop DLL, a first driver DRV1, a command parser CMDP, a packet generator PKG, a packet parser PKP, and a voltage and current generator VCG.

The mode storage MS may include information about various operation modes of the nonvolatile memory device 110_1, 110_2, 110_3, or 110_4. For example, the mode storage MS may store information about whether the nonvolatile memory device 110_1, 110_2, 110_3, or 110_4 currently operates in a normal mode complying with the communication standard of the nonvolatile memory device 110_1, 110_2, 110_3, or 110_4 or in a legacy mode complying with an earlier version of the communication standard. The mode storage MS may store information about whether to activate or deactivate the inter-device communication (or the inter-die communication) of the nonvolatile memory device 110_1, 110_2, 110_3, or 110_4. The mode storage MS may store information about a way to (e.g., a method or a technique to used) exchange information based on the inter-device communication (or the inter-die communication) being activated. The control logic CL may control the operations of the nonvolatile memory device 110_1, 110_2, 110_3, or 110_4, based on the information stored in the mode storage MS.

In addition to the above information, the mode storage MS may store various information about the operation mode of the nonvolatile memory device 110_1, 110_2, 110_3, or 110_4. In an embodiment, the mode storage MS may include nonvolatile storage elements or volatile storage elements such as an SRAM cell or a DRAM cell. The nonvolatile storage elements may include, but is not limited to, an electrical fuse. The volatile storage elements may include, but is not limited to, an SRAM cell or a DRAM cell.

The first latch LC1 may latch signals received through the first signal lines SIGL1. A synchronization signal which is used for the first latch LC1 to latch a signal and the signal which is latched by the first latch LC1 may change. For example, inputs of the first latch LC1 may be multiplexed. In an example, the first latch LC1 may latch a first signal in synchronization with a second signal. When the first signal and the second signal are multiplexed (or changed), the first latch LC1 may latch the second signal in synchronization with the first signal. The control logic CL may operate based on a signal latched by the first latch LC1.

The delay locked loop DLL may receive a clock signal, may adjust a delay amount of the clock signal, and may output the delayed clock signal. The clock signal received by the delay locked loop DLL may change. For example, an input of the delay locked loop DLL may be multiplexed. In an example, the delay locked loop DLL may latch a third signal in synchronization with a fourth signal. When the third signal and the fourth signal are multiplexed (or changed), the delay locked loop DLL may latch the fourth signal in synchronization with the third signal. The control logic CL may operate based on the clock signal output from the delay locked loop DLL.

The first driver DRV1 may be used for the control logic CL to transmit a signal to the first signal lines SIGL1 during the inter-device communication.

The command parser CMDP may parse a command received from the memory controller 120 and may output a result of the parsing. The control logic CL may operate depending on the parsing result and may control the nonvolatile memory device 110_1, 110_2, 110_3, or 110_4.

In an example case in which the inter-device communication is performed, the packet generator PKG may generate a packet for the inter-device communication based on the information about the way to exchange, which is stored in the mode storage MS. The generated packet may be output to the first signal lines SIGL1 through the first driver DRV1.

In an example case in which the inter-device communication is activated and a packet is received through the first signal lines SIGL1 based on the inter-device communication, the packet parser PKP may parse the received packet and may output a result of the parsing. The control logic CL may store the parsing result. For example, the parsing result may include information transferred from any other nonvolatile memory device 110_1, 110_2, 110_3, or 110_4. The information transferred from another nonvolatile memory device 110_1, 110_2, 110_3, or 110_4 may include, but is not limited to, the peak current information, the temperature information, or the status information.

The voltage and current generator VCG may generate a voltage and a current which are used in the nonvolatile memory device 110_1, 110_2, 110_3, or 110_4. The voltage and current generator VCG may detect the peak current and may provide information about the detected peak current to the control logic CL. The control logic CL may store the peak current information together with the information parsed by the packet parser PKP. Also, the control logic CL may also store the temperature information and the status information of the nonvolatile memory device 110_1, 110_2, 110_3, or 110_4 in which the control logic CL is included, together with the peak current information and the parsed information.

The data buffer DTB may include, but is not limited to, a second driver DRV2 and a second latch LC2. The second driver DRV2 may be used to transmit the data strobe signals DQS[1:m] and the data signals DQ[1:n] to the second signal lines SIGL2. For example, the data buffer DTB uses the second driver DRV2 to transmit the data strobe signals DQS[1:m] and the data signals DQ[1:n] to the second signal lines SIGL2. The second latch LC2 may be used to latch the data strobe signals DQS[1:m] and the data signals DQ[1:n] from the second signal lines SIGL2. For example, the data buffer DTB uses the second latch to latch the data strobe signals DQS[1:m] and the data signals DQ[1:n] received from the second signal lines SIGL2.

According to embodiments of the disclosure, the control logic CL may include the first driver DRV1 for the inter-device communication. However, embodiments of the disclosure are not limited thereto. For example, the control logic CL may transfer the packet generated by the packet generator PKG to the data buffer DTB, and the second driver DRV2 of the data buffer DTB may output the packet to the first signal lines SIGL1. The output of the second driver DRV2 may be demultiplexed to be output to either the first signal lines SIGL1 or the second signal lines SIGL2. In this case, the first driver DRV1 of the control logic CL may be omitted.

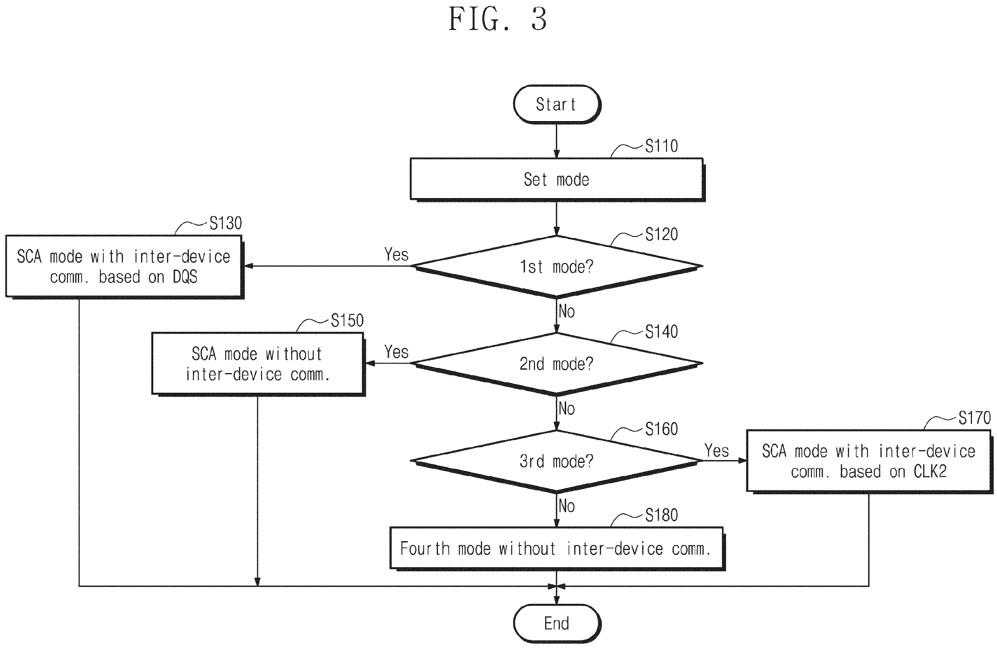

FIG. 3 is a flowchart illustrating an operating method of the storage device 100 according to an embodiment of the disclosure. Referring to FIGS. 1, 2, and 3, in operation S110, the method may include setting a mode of operation. For example, the storage device 100 may set a mode. For example, the memory controller 120 may set the first nonvolatile memory device 110_1, the second nonvolatile memory device 110_2, the third nonvolatile memory device 110_3, and the fourth nonvolatile memory device 110_4 to operate in a mode associated with the inter-device communication.

In an embodiment, the description will be given as the memory controller 120 sets one of a first mode, a second mode, a third mode, and a fourth mode to the first nonvolatile memory device 110_1, the second nonvolatile memory device 110_2, the third nonvolatile memory device 110_3, and the fourth nonvolatile memory device 110_4, but modes of embodiments of the disclosure are not limited by the number of the modes or the order of the modes.

In an example case in which the memory controller120 is powered on, the memory controller 120 may set or change the mode based on a request of an external host device or an internal policy.

In operation S120, the method may include determining whether the nonvolatile memory device 110_1, 110_2, 110_3, or 110_4 is set to the first mode. For example, the first nonvolatile memory device 110_1, the second nonvolatile memory device 110_2, the third nonvolatile memory device 110_3, and/or the fourth nonvolatile memory device 110_4 may determine whether the respective nonvolatile memory device 110_1, 110_2, 110_3, or 110_4 is set to the first mode. For example, the control logic CL of the respective nonvolatile memory device 110_1, 110_2, 110_3, or 110_4 may identify the set mode, based on mode information stored in the mode storage MS.

In an example case in which the nonvolatile memory device 110_1, 110_2, 110_3, or 110_4 is set to the first mode, in operation S130, the method may include setting the nonvolatile memory device 110_1, 110_2, 110_3, or 110_4 to a separate command and address (SCA) mode which is based on a data strobe signal DQS. For example, the nonvolatile memory device 110_1, 110_2, 110_3, or 110_4 may be set to a separate command and address (SCA) mode which is based on a data strobe signal DQS.

In the SCA mode, the memory controller 120 may transmit a clock signal, a command, and an address as the control signals CS[1:j] to the first nonvolatile memory device 110_1, the second nonvolatile memory device 110_2, the third nonvolatile memory device 110_3, and the fourth nonvolatile memory device 110_4 through the first signal lines SIGL1. In the SCA mode, the memory controller 120 may transmit data bits as the data signals DQ[1:n] to the first nonvolatile memory device 110_1, the second nonvolatile memory device 110_2, the third nonvolatile memory device 110_3, and the fourth nonvolatile memory device 110_4 through the second signal lines SIGL2.

While the memory controller 120 does not transmit the clock signal, the command, and the address through the first signal lines SIGL1 and while the memory controller 120 transmits or receives the data signals DQ[1:n] in synchronization with the data strobe signals DQS[1:m], the first nonvolatile memory device 110_1, the second nonvolatile memory device 110_2, the third nonvolatile memory device 110_3, and the fourth nonvolatile memory device 110_4 may perform the inter-device communication in synchronization with the data strobe signal DQS.

According to an embodiment, based on a determination in operation S120 that the nonvolatile memory device 110_1, 110_2, 110_3, or 110_4 is not set to the first mode, in operation S140, the method may include determining whether the nonvolatile memory device 110_1, 110_2, 110_3, or 110_4 is set to the second mode.

In an example case in which the nonvolatile memory device 110_1, 110_2, 110_3, or 110_4 is set to the second mode, in operation S150, the method may include setting the nonvolatile memory device 110_1, 110_2, 110_3, or 110_4 to a separate command and address (SCA) mode without the inter-device communication. For example, the nonvolatile memory device 110_1, 110_2, 110_3, or 110_4 may be set to the SCA mode without the inter-device communication (or in which the inter-device communication is not performed or omitted).

According to an embodiment, based on a determination in operation S140 that the nonvolatile memory device 110_1, 110_2, 110_3, or 110_4 is not set to the second mode, in operation S160, the method may include determining whether the nonvolatile memory device 110_1, 110_2, 110_3, or 110_4 is set to the third mode.

In an example case in which the nonvolatile memory device 110_1, 110_2, 110_3, or 110_4 is set to the third mode, in operation S170, the method may include setting the nonvolatile memory device 110_1, 110_2, 110_3, or 110_4 to a separate command and address (SCA) mode with the inter-device communication which is based on a second clock signal CLK2. For example, the nonvolatile memory device 110_1, 110_2, 110_3, or 110_4 may be set to the SCA mode with the inter-device communication which is based on a second clock signal CLK2 (or to the SCA mode in which the inter-device communication based on the second clock signal CLK2 is performed). In an embodiment, the second clock signal CLK2 may be distinguished from the clock signal which is transmitted to the first nonvolatile memory device 110_1, the second nonvolatile memory device 110_2, the third nonvolatile memory device 110_3, and the fourth nonvolatile memory device 110_4. For example, the second clock signal CLK2 may be generated by any one of the first nonvolatile memory device 110_1, the second nonvolatile memory device 110_2, the third nonvolatile memory device 110_3, and the fourth nonvolatile memory device 110_4.

According to an embodiment, based on a determination in operation S160 that the nonvolatile memory device 110_1, 110_2, 110_3, or 110_4 is not set to the third mode, the nonvolatile memory device 110_1, 110_2, 110_3, or 110_4 is identified as being set to the fourth mode. In operation S180, the method may include determining whether the nonvolatile memory device 110_1, 110_2, 110_3, or 110_4 may be set to a fourth mode without the inter-device communication. According to an embodiment, the fourth mode may be a legacy mode.

In the legacy mode, the memory controller 120 may transmit a write enable signal and an address enable signal as the control signals CS[1:j] to the first nonvolatile memory device 110_1, the second nonvolatile memory device 110_2, the third nonvolatile memory device 110_3, and the fourth nonvolatile memory device 110_4 through the first signal lines SIGL1. In the legacy mode, the memory controller 120 may transmit data bits, a command, and an address as the data signals DQ[1:n] to the first nonvolatile memory device 110_1, the second nonvolatile memory device 110_2, the third nonvolatile memory device 110_3, and the fourth nonvolatile memory device 110_4 through the second signal lines SIGL2.

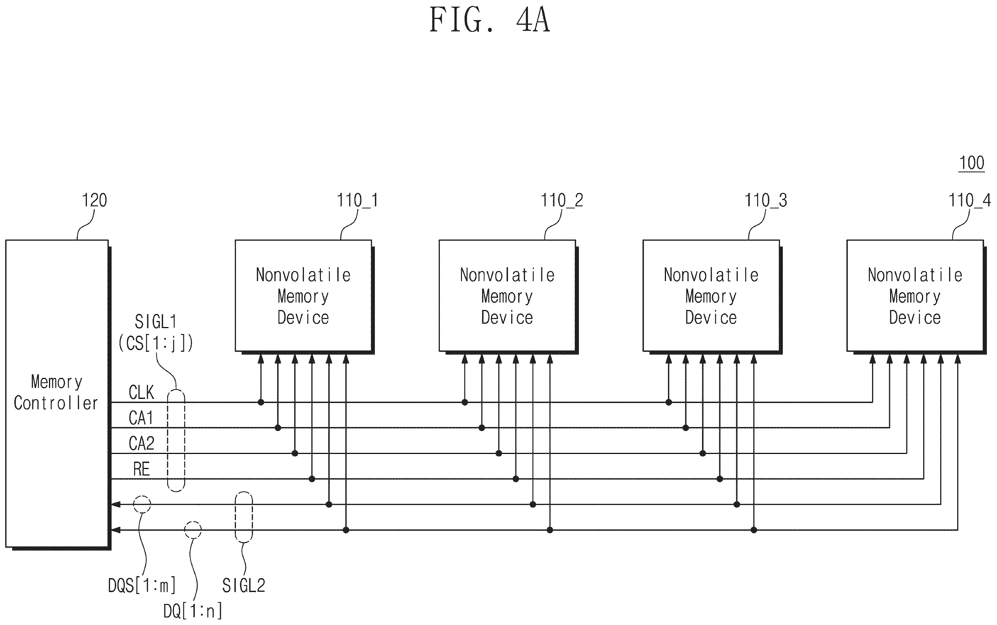

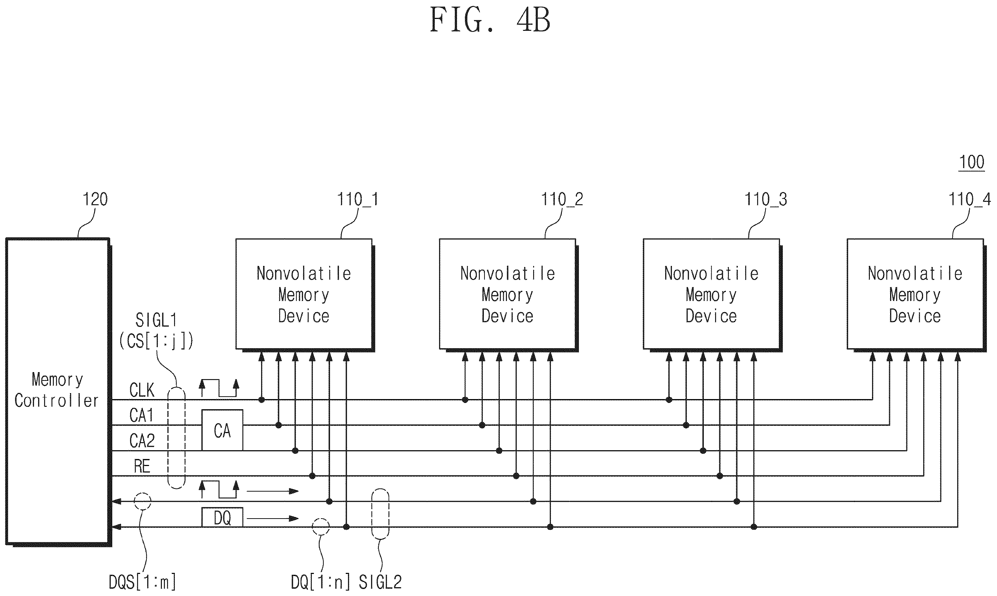

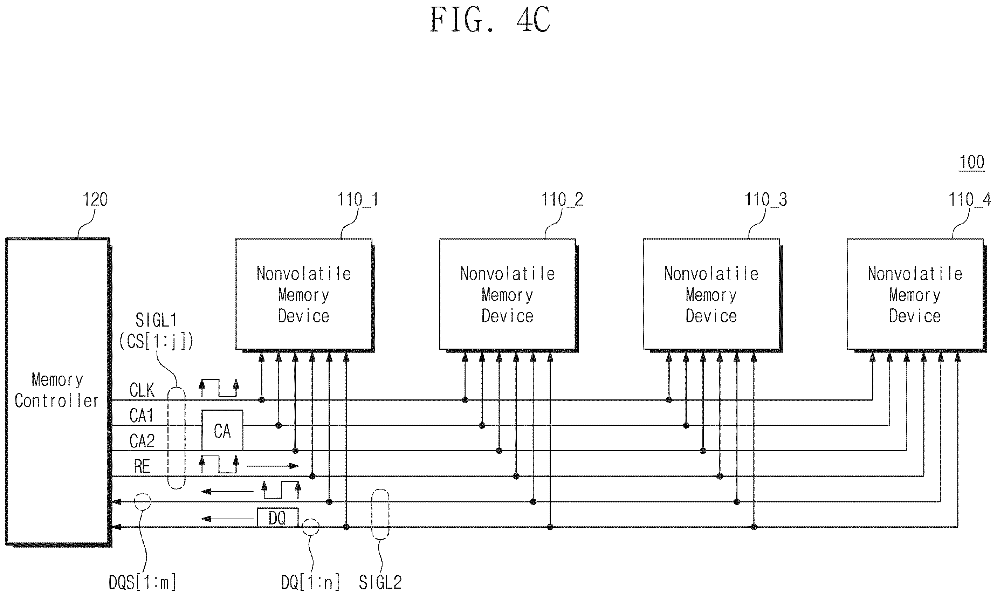

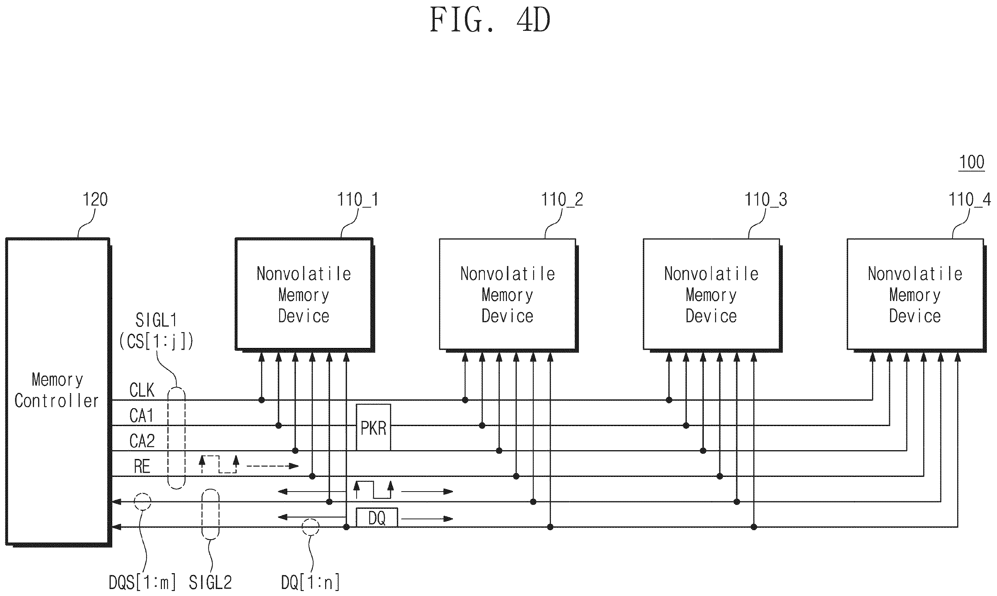

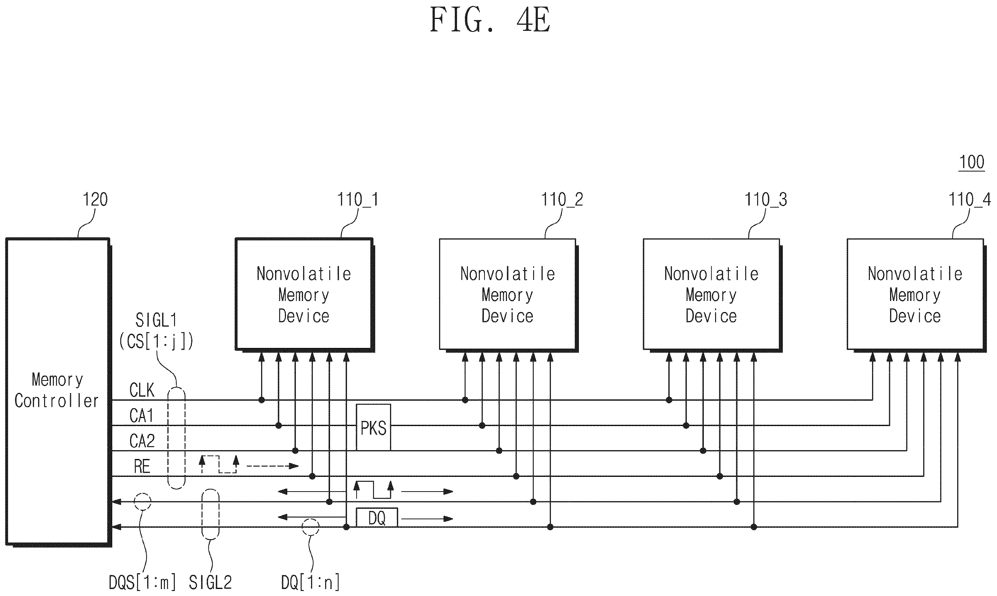

FIGS. 4A, 4B, 4C, 4D, and 4E illustrate examples in which the storage device 100 operates in the SCA mode with the inter-device communication based on a data strobe signal. In an embodiment, an example of the first mode of FIG. 2, in which the first nonvolatile memory device 110_1, the second nonvolatile memory device 110_2, the third nonvolatile memory device 110_3, and the fourth nonvolatile memory device 110_4 performs the inter-device communication based on any one of the data strobe signals DQS[1:m] without control of the memory controller 120, is illustrated in FIGS. 4A, 4B, 4C, 4D, and 4E.

Referring to FIG. 4A, the control signals CS[1:j] may include a clock signal CLK, a first command address signal CA1, a second command address signal CA2, and a read enable signal RE. The first signal lines SIGL1 may be configured to transfer the clock signal CLK, the first command address signal CA1, the second command address signal CA2, and the read enable signal RE.

FIG. 4B illustrates an example in which the storage device 100 performs the write operation in the SCA mode with the inter-device communication. Referring to FIGS. 2 and 4B, in an example case in which the memory controller 120 intends to transmit a command and address CA to the first nonvolatile memory device 110_1, the second nonvolatile memory device 110_2, the third nonvolatile memory device 110_3, and the fourth nonvolatile memory device 110_4, first, the memory controller 120 may generate and output the clock signal CLK. In synchronization with the clock signal CLK, the memory controller 120 may output the command and address CA as the first command address signal CA1 and the second command address signal CA2.

According to an embodiment, a nonvolatile memory device, among the first nonvolatile memory device 110_1, the second nonvolatile memory device 110_2, the third nonvolatile memory device 110_3, and the fourth nonvolatile memory device 110_4, may be selected by a chip enable signal of the memory controller 120. The first latch LC1 of the control logic CL of the selected nonvolatile memory device 110_1, 110_2, 110_3, or 110_4 may latch the command and address CA in synchronization with the clock signal CLK. The command parser CMDP of the control logic CL may parse the command and address CA.

According to an embodiment, at a same time at which the command and address CA is output, the memory controller 120 may generate and output the data strobe signals DQS[1:m] . The memory controller 120 may transmit data DQ as the data signals DQ[1:n] in synchronization with the data strobe signals DQS[1:m].

The second latch LC2 of the data buffer DTB of the selected nonvolatile memory device 110_1, 110_2, 110_3, or 110_4 may latch the data DQ in synchronization with the data strobe signals DQS[1:m].

The first signal lines SIGL1 and the second signal lines SIGL2 may be separated from each other. For example, signals of the first signal lines SIGL1 may be synchronized with the clock signal CLK, and signals of the second signal lines SIGL2 may be synchronized with the data strobe signal DQS. Accordingly, the memory controller 120 may simultaneously output signals through the first signal lines SIGL1 and the second signal lines SIGL2.

In an embodiment, the data DQ may be data corresponding to a current command and address CA or data corresponding to a previous command and address. In another embodiment, the memory controller 120 may receive the data DQ corresponding to a previous read command from the selected nonvolatile memory device 110_1, 110_2, 110_3, or 110_4.

In an embodiment, while the memory controller 120 outputs one of the first command address signal CA1, the second command address signal CA2, and the clock signal CLK, the first nonvolatile memory device 110_1, the second nonvolatile memory device 110_2, the third nonvolatile memory device 110_3, and the fourth nonvolatile memory device 110_4 may not attempt the inter-device communication.

FIG. 4C illustrates an example in which the storage device 100 performs the read operation in the SCA mode with the inter-device communication. Referring to FIG. 4C, in an example case in which the memory controller 120 intends to transmit the command and address CA to the first nonvolatile memory device 110_1, the second nonvolatile memory device 110_2, the third nonvolatile memory device 110_3, and the fourth nonvolatile memory device 110_4, first, the memory controller 120 may generate and output the clock signal CLK. In synchronization with the clock signal CLK, the memory controller 120 may output the command and address signal CA as the first command address signal CA1 and the second command address signal CA2.

According to an embodiment, a nonvolatile memory device, among the first nonvolatile memory device 110_1, the second nonvolatile memory device 110_2, the third nonvolatile memory device 110_3, and the fourth nonvolatile memory device 110_4, may be selected by a chip enable signal of the memory controller 120. The first latch LC1 of the control logic CL of the selected nonvolatile memory device 110_1, 110_2, 110_3, or 110_4 may latch the command and address CA in synchronization with the clock signal CLK. The command parser CMDP of the control logic CL may parse the command and address CA.

According to an embodiment, at a same time (or a similar time) at which the command and address CA is output, the memory controller 120 may generate the read enable signal RE and may transmit the read enable signal RE to the first nonvolatile memory device 110_1, the second nonvolatile memory device 110_2, the third nonvolatile memory device 110_3, and the fourth nonvolatile memory device 110_4.

The selected nonvolatile memory device 110_1, 110_2, 110_3, or 110_4 among the first nonvolatile memory device 110_1, the second nonvolatile memory device 110_2, the third nonvolatile memory device 110_3, and the fourth nonvolatile memory device 110_4 may delay the read enable signal RE to generate the data strobe signals DQS[1:m]. For example, the delay locked loop DLL of the control logic CL may delay the read enable signal RE to generate the data strobe signals DQS[1:m]. The data strobe signals DQS[1:m] may be transferred to the data buffer DTB. The second driver DRV2 of the data buffer DTB may output the data strobe signals DQS[1:m]. Also, the second driver DRV2 of the data buffer DTB may output the data DQ transferred from the core circuit.

After outputting the command and address CA, the memory controller 120 may receive the data strobe signals DQS[1:m] from the selected nonvolatile memory device 110_1, 110_2, 110_3, or 110_4. The memory controller 120 may receive the data DQ as the data signals DQ[1:n] from the selected nonvolatile memory device 110_1, 110_2, 110_3, or 110_4 in synchronization with the data strobe signals DQS[1:m].

The first signal lines SIGL1 and the second signal lines SIGL2 may be separated from each other. Signals of the first signal lines SIGL1 may be synchronized with the clock signal CLK, and signals of the second signal lines SIGL2 may be synchronized with the data strobe signal DQS. Accordingly, the memory controller 120 may receive signals through the second signal lines SIGL2 while outputting signals through the first signal lines SIGL1.

In an embodiment, the data DQ may be data corresponding to a current command and address CA or data corresponding to a previous command and address. In another embodiment, the memory controller 120 may transmit the data DQ corresponding to a previous write command to the selected nonvolatile memory device 110_1, 110_2, 110_3, or 110_4.

FIG. 4D illustrates an example in which the first nonvolatile memory device 110_1, the second nonvolatile memory device 110_2, the third nonvolatile memory device 110_3, and the fourth nonvolatile memory device 110_4 perform the inter-device communication based on the data strobe signal DQS without control of the memory controller 120. Referring to FIGS. 2 and 4D, the inter-device communication may be performed while the memory controller 120 does not output the clock signal CLK, the first command address signal CA1, and the second command address signal CA2.

In an embodiment, the inter-device communication may be performed while the memory controller 120 communicates the data strobe signals DQS[1:m] and the data signals DQ[1:n] with the selected nonvolatile memory device 110_1, 110_2, 110_3, or 110 _4.

In an embodiment, one of the first nonvolatile memory device 110_1, the second nonvolatile memory device 110_2, the third nonvolatile memory device 110_3, and the fourth nonvolatile memory device 110_4 may be designated as a "primary nonvolatile memory device", and one or more of the remaining ones of the first nonvolatile memory device 110_1, the second nonvolatile memory device 110_2, the third nonvolatile memory device 110_3, and the fourth nonvolatile memory device 110_4 may be designated as a "secondary nonvolatile memory device". According to an example embodiment, the primary nonvolatile memory device may be referred to as a main nonvolatile memory device, and the secondary nonvolatile memory device may be referred to as sub-nonvolatile memory device.

For example, the primary nonvolatile memory device may be determined depending on an internal policy of the memory controller 120 or depending on serial numbers of the first nonvolatile memory device 110_1, the second nonvolatile memory device 110_2, the third nonvolatile memory device 110_3, and the fourth nonvolatile memory device 110_4. In an embodiment, the first nonvolatile memory device 110_1 may be the primary nonvolatile memory device. As such, the first nonvolatile memory device 110_1 may be the primary nonvolatile memory device in some example embodiments described below.

In an example case in which the clock signal CLK is not received from the memory controller 120, for example, when a threshold time passes after the clock signal CLK is deactivated and when the primary nonvolatile memory device 110_1 is communicating with the data strobe signals DQS[1:m] with the memory controller 120, the primary nonvolatile memory device 110_1 may start the inter-device communication. The threshold time may include, but is not limited to, a time determined in manufacturing or a time determined by the memory controller 120. In an embodiment, based on the memory controller 120 receiving the data DQ from the nonvolatile memory device 110_1, 110_2, 110_3, or 110_4, the read enable signal RE may also toggle.

The packet generator PKG of the control logic CL of the primary nonvolatile memory device 110_1 may generate a request packet PKR for requesting the inter-device communication. The first driver DRV1 of the control logic CL of the primary nonvolatile memory device 110_1 may output the request packet PKR to signal lines, through which the first command address signal CA1 and the second command address signal CA2 are transferred, from among the first signal lines SIGL1 in synchronization with any one of the data strobe signals DQS[1:m].

The request packet PKR may be transferred to the second nonvolatile memory device 110_2, the third nonvolatile memory device 110_3, the fourth nonvolatile memory device 110_4, and the memory controller 120. The memory controller 120 may ignore the request packet PKR.

Each of the second nonvolatile memory device 110_2, the third nonvolatile memory device 110_3, and the fourth nonvolatile memory device 110_4 may receive the request packet PKR by using the first latch LC1 of the control logic CL. For example, the first latch LC1 may latch the request packet PKR in synchronization with any one of the data strobe signals DQS[1:m].

In an embodiment, based on the chip enable signal line corresponding to each of the second nonvolatile memory device 110_2, the third nonvolatile memory device 110_3, and the fourth nonvolatile memory device 110_4 being activated, the first latch LC1 of the control logic CL may latch the first command address signal CA1 and the second command address signal CA2 in synchronization with the clock signal CLK. Each of the second nonvolatile memory device 110_2, the third nonvolatile memory device 110_3, and the fourth nonvolatile memory device 110_4 may parse the command transmitted from the memory controller 120 by using the command parser CMDP of the control logic CL.

In an example case in which the clock signal CLK is not received and based on the data strobe signals DQS[1:m] being in an active state (e.g., are toggling), the first latch LC1 of the control logic CL of the second nonvolatile memory device 110_2, the third nonvolatile memory device 110_3, and the fourth nonvolatile memory device 110_4 may latch a signal of a signal line transferring the first command address signal CA1 and a signal of a signal line transferring the second command address signal CA2 in synchronization with any one of the data strobe signals DQS[1:m]. Each of the second nonvolatile memory device 110_2, the third nonvolatile memory device 110_3, and the fourth nonvolatile memory device 110_4 may parse the request packet PKR transmitted from the memory controller 120 by using the packet parser PKP of the control logic CL.

In an example case in which the memory controller 120 outputs the clock signal CLK while performing the inter-device communication, the first nonvolatile memory device 110_1, the second nonvolatile memory device 110_2, the third nonvolatile memory device 110_3, and the fourth nonvolatile memory device 110_4 may be configured to stop the inter-device communication. For example, the nonvolatile memory device 110_1, 110_2, 110_3, or 110_4 may be configured to stop the inter-device communication and to complete the preparation to receive the command and address CA from the memory controller 120, before the threshold number of cycles of the clock signal CLK (e.g., the threshold number of cycles set in manufacturing or by the memory controller 120) passes.

FIG. 4E illustrates an example in which the first nonvolatile memory device 110_1, the second nonvolatile memory device 110_2, the third nonvolatile memory device 110_3, and the fourth nonvolatile memory device 110_4 perform the inter-device communication based on the data strobe signal DQS without control of the memory controller 120. In an embodiment, an example of an operation which is performed following FIG. 4D is illustrated in FIG. 4E. Referring to FIGS. 2 and 4E, the inter-device communication may be continued while the memory controller 120 does not output the clock signal CLK, the first command address signal CA1, and the second command address signal CA2.

In an embodiment, the inter-device communication may be continued while the memory controller 120 communicates the data strobe signals DQS[1:m] and the data signals DQ[1:n] with the selected nonvolatile memory device 110_1, 110_2, 110_3, or 110_4. In an embodiment, based on the memory controller 120 receiving the data DQ from the nonvolatile memory device 110_1, 110_2, 110_3, or 110_4, the read enable signal RE may also toggle.

In an example case in which the clock signal CLK is not received from the memory controller 120, each of the second nonvolatile memory device 110_2, the third nonvolatile memory device 110_3, and the fourth nonvolatile memory device 110_4 may transmit a response packet PKS to the primary nonvolatile memory device 110_1 based on the request packet PKR. For example, in response to the request packet PKR, each of the second nonvolatile memory device 110_2, the third nonvolatile memory device 110_3, and the fourth nonvolatile memory device 110_4 may transmit a response packet PKS to the primary nonvolatile memory device 110_1.

The packet generator PKG of the control logic CL of each of the second nonvolatile memory device 110_2, the third nonvolatile memory device 110_3, and the fourth nonvolatile memory device 110_4 may generate the response packet PKS for providing device information in response to a request of the request packet PKR. The first driver DRV1 of the control logic CL of each of the second nonvolatile memory device 110_2, the third nonvolatile memory device 110_3, and the fourth nonvolatile memory device 110_4 may output the response packet PKS to signal lines, through which the first command address signal CA1 and the second command address signal CA2 are transferred, from among the first signal lines SIGL1 in synchronization with any one of the data strobe signals DQS[1:m].

The response packet PKS may be transferred to the primary nonvolatile memory device 110_1 and the memory controller 120. The memory controller 120 may ignore the response packet PKS.

In an embodiment, the second nonvolatile memory device 110_2, the third nonvolatile memory device 110_3, and the fourth nonvolatile memory device 110_4 may sequentially output the response packet PKS. The order in which the second nonvolatile memory device 110_2, the third nonvolatile memory device 110_3, and the fourth nonvolatile memory device 110_4 output the response packet PKS may be determined by the memory controller 120, for example, based on the serial number.

The primary nonvolatile memory device 110_1 may receive the response packet PKS by using the first latch LC1 of the control logic CL. For example, the first latch LC1 may latch the response packet PKS in synchronization with any one of the data strobe signals DQS[1:m].

In an embodiment, based on the chip enable signal corresponding to the primary nonvolatile memory device 110_1 being activated, the first latch LC1 of the control logic CL may latch the first command address signal CA1 and the second command address signal CA2 in synchronization with the clock signal CLK. The primary nonvolatile memory device 110_1 may parse the command transmitted from the memory controller 120 by using the command parser CMDP of the control logic CL.

In an example case in which the clock signal CLK is not received and based on the data strobe signals DQS[1:m] being in an active state (e.g., are toggling), the first latch LC1 of the control logic CL of the primary nonvolatile memory device 110_1 may latch the first command address signal CA1 and the second command address signal CA2 in synchronization with any one of the data strobe signals DQS[1:m]. The primary nonvolatile memory device 110_1 may parse the response packet PKS transmitted from the memory controller 120 by using the packet parser PKP of the control logic CL.

According to an embodiment, based on parsing the response packet PKS, the primary nonvolatile memory device 110_1 may include information of the second nonvolatile memory device 110_2, the third nonvolatile memory device 110_3, and the fourth nonvolatile memory device 110_4. The control logic CL of the primary nonvolatile memory device 110_1 may store and manage information of the primary nonvolatile memory device 110_1 together with the information of the second nonvolatile memory device 110_2, the third nonvolatile memory device 110_3, and the fourth nonvolatile memory device 110_4.

In an example case in which the memory controller 120 outputs the clock signal CLK while performing the inter-device communication, the first nonvolatile memory device 110_1, the second nonvolatile memory device 110_2, the third nonvolatile memory device 110_3, and the fourth nonvolatile memory device 110_4 may be configured to stop the inter-device communication. For example, the nonvolatile memory device 110_1, 110_2, 110_3, or 110_4 may be configured to stop the inter-device communication and to complete the preparation to receive the command and address CA from the memory controller 120, before the threshold number cycles of the clock signal CLK (e.g., the threshold number of cycles set in manufacturing or by the memory controller 120) passes.

In an example case in which the inter-device communication is stopped, the primary nonvolatile memory device 110_1 may discard information collected during the stopped inter-device communication. In another example case in which the inter-device communication is stopped, the primary nonvolatile memory device 110_1 may store information of nonvolatile memory devices, which is completely received up to now, and may discard information of nonvolatile memory devices, which is partially received.

In an embodiment, as described in the second mode of FIG. 3, the storage device 100 may be set to the SCA mode in which the inter-device communication is not performed. For example, in a case in which an operation of requiring a frequent access is performed, the inter-device communication may be deactivated to maximize the throughput. For example, the operation of requiring a frequent access may include, but is not limited to, a scrub operation of verifying the integrity of data stored in the storage device 100.

In another example case in which the access frequency belongs to a relatively low time period, based on a history over time or based on an access pattern of the user, the change in information of the first nonvolatile memory device 110_1, the second nonvolatile memory device 110_2, the third nonvolatile memory device 110_3, and the fourth nonvolatile memory device 110_4 may be expected as being small; in this case, the inter-device communication may be deactivated. The activation and deactivation of the inter-device communication may be determined by the memory controller 120 or the external host device communicating with the memory controller 120.

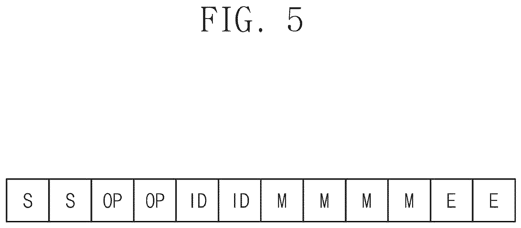

FIG. 5 illustrates an example of the request packet PKR and the response packet PKS according to an embodiment of the disclosure. Referring to FIGS. 4D, 4E, and 5, information packet including the request packet PKR and the response packet PKS may include a start pattern including at least two start bits "S", an opcode pattern including at least two opcode bits OP, an identifier pattern including at least two identifier bits ID, a message pattern including at least two message bits "M", and an end pattern including at least two end bits "E".

The start pattern including at least two start bits "S" may indicate a start of the information packet. The second nonvolatile memory device 110_2, the third nonvolatile memory device 110_3, and the fourth nonvolatile memory device 110_4 may identify that the information packet is received as the first command address signal CA1 and the second command address signal CA2, by identifying the start pattern. The primary nonvolatile memory device 110_1 may identify that the information packet is received, by identifying the start pattern.

The opcode pattern including at least two opcode bits OP may indicate whether the information packet is the request packet PKR or the response packet PKS. The identifier pattern including at least two identifier bits ID may indicate a nonvolatile memory device which transmits the information packet.

The message information including at least two message bits "M" may include information. For example, the message pattern of the request packet PKR may indicate information requested or required by the primary nonvolatile memory device 110_1. For example, the message pattern of the request packet PKR may indicate a kind (or a type) of information required or requested by the primary nonvolatile memory device 110_1. The message pattern of the response packet PKS may include information of each of the second nonvolatile memory device 110_2, the third nonvolatile memory device 110_3, and the fourth nonvolatile memory device 110_4, which is requested by the request packet PKR.

The end pattern including at least two end bits "E" may indicate an end of the information pattern.

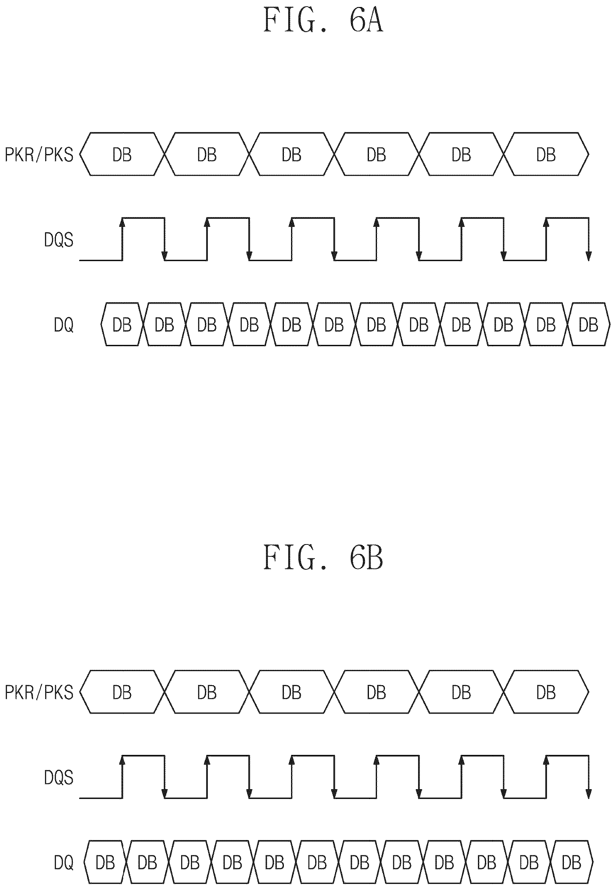

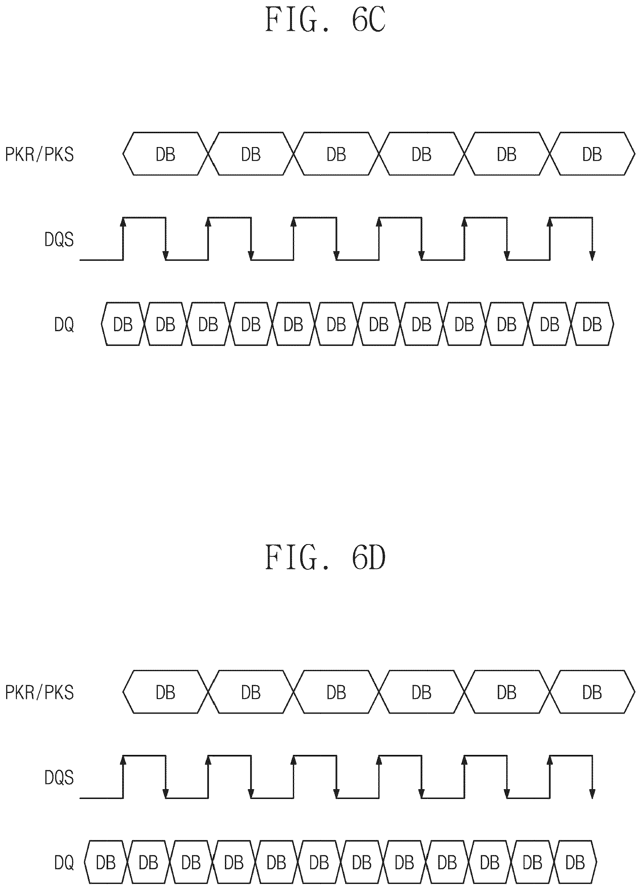

FIGS. 6A, 6B, 6C, and 6D illustrate an example in which the nonvolatile memory device 110_1, 110_2, 110_3, or 110_4 communicates data bits DB of the data DQ and data bits DB of the request packet PKR and the response packet PKS in synchronization with the data strobe signal DQS (e.g., any one of the data strobe signals DQS[1:m]).

Referring to FIGS. 4D, 4E, and 6A, the memory controller 120 may align the centers of the data bits DB of the data DQ with the rising edges and the falling edges of the data strobe signal DQS. For example, based on a double data rate (DDR) scheme, the data bits DB of the data DQ may be transmitted from the memory controller 120 to the first nonvolatile memory device 110_1, the second nonvolatile memory device 110_2, the third nonvolatile memory device 110_3, and the fourth nonvolatile memory device 110_4.

The first nonvolatile memory device 110_1, the second nonvolatile memory device 110_2, the third nonvolatile memory device 110_3, and the fourth nonvolatile memory device 110_4 may align the centers of the request packet PKR and the response packet PKS with the rising edges of the data strobe signal DQS. The first nonvolatile memory device 110_1, the second nonvolatile memory device 110_2, the third nonvolatile memory device 110_3, and the fourth nonvolatile memory device 110_4 may transmit the request packet PKR and the response packet PKS based on a single data rate (SDR) scheme.

For example, the delay locked loop DLL of the data buffer DTB included in the control logic CL of the nonvolatile memory device 110_1, 110_2, 110_3, or 110_4 may generate an internal clock signal aligned with the centers of the data bits DB of the request packet PKR or the response packet PKS and may provide the internal clock signal to the first driver DRV1 of the control logic CL. The first driver DRV1 may output the data bits DB of the request packet PKR and the response packet PKS in synchronization with the internal clock signal. In another example, the first driver DRV1 of the control logic CL may output the data bits DB of the request packet PKR or the response packet PKS in synchronization with the falling edges of the data strobe signal DQS.

The first latch LC1 of the control logic CL of the nonvolatile memory device 110_1, 110_2, 110_3, or 110_4 may latch the data bits DB of the request packet PKR or the response packet PKS in synchronization with the rising edges of the data strobe signal DQS.

Referring to FIGS. 4D, 4E, and 6B, the nonvolatile memory device 110_1, 110_2, 110_3, or 110_4 may align the edges of the data bits DB of the data DQ with the rising edges and the falling edges of the data strobe signal DQS. For example, based on the double data rate (DDR) scheme, the data bits DB of the data DQ may be transmitted from the first nonvolatile memory device 110_1, the second nonvolatile memory device 110_2, the third nonvolatile memory device 110_3, and the fourth nonvolatile memory device 110_4 to the memory controller 120.

The first nonvolatile memory device 110_1, the second nonvolatile memory device 110_2, the third nonvolatile memory device 110_3, and the fourth nonvolatile memory device 110_4 may align the centers of the request packet PKR and the response packet PKS with the rising edges of the data strobe signal DQS. The first nonvolatile memory device 110_1, the second nonvolatile memory device 110_2, the third nonvolatile memory device 110_3, and the fourth nonvolatile memory device 110_4 may transmit the request packet PKR and the response packet PKS based on the single data rate (SDR) scheme.

For example, the delay locked loop DLL of the data buffer DTB included in the control logic CL of the nonvolatile memory device 110_1, 110_2, 110_3, or 110_4 may generate the internal clock signal aligned with the centers of the data bits DB of the request packet PKR or the response packet PKS and may provide the internal clock signal to the first driver DRV1 of the control logic CL. The first driver DRV1 may output the data bits DB of the request packet PKR and the response packet PKS in synchronization with the internal clock signal. In another example, the first driver DRV1 of the control logic CL may output the data bits DB of the request packet PKR or the response packet PKS in synchronization with the falling edges of the data strobe signal DQS.

The first latch LC1 of the control logic CL of the nonvolatile memory device 110_1, 110_2, 110_3, or 110_4 may latch the data bits DB of the request packet PKR or the response packet PKS in synchronization with the rising edges of the data strobe signal DQS.

Referring to FIGS. 4D, 4E, and 6C, the memory controller 120 may align the centers of the data bits DB of the data DQ with the rising edges and the falling edges of the data strobe signal DQS. For example, based on the double data rate (DDR) scheme, the data bits DB of the data DQ may be transmitted from the memory controller 120 to the first nonvolatile memory device 110_1, the second nonvolatile memory device 110_2, the third nonvolatile memory device 110_3, and the fourth nonvolatile memory device 110_4.

The first nonvolatile memory device 110_1, the second nonvolatile memory device 110_2, the third nonvolatile memory device 110_3, and the fourth nonvolatile memory device 110_4 may align the edges of the request packet PKR and the response packet PKS with the rising edges of the data strobe signal DQS. For example, the first nonvolatile memory device 110_1, the second nonvolatile memory device 110_2, the third nonvolatile memory device 110_3, and the fourth nonvolatile memory device 110_4 may transmit the data bits DB of the request packet PKR or the response packet PKS in synchronization with the rising edges of the data strobe signal DQS. The first nonvolatile memory device 110_1, the second nonvolatile memory device 110_2, the third nonvolatile memory device 110_3, and the fourth nonvolatile memory device 110_4 may transmit the request packet PKR and the response packet PKS based on the single data rate (SDR) scheme.

For example, the delay locked loop DLL of the data buffer DTB included in the control logic CL of the nonvolatile memory device 110_1, 110_2, 110_3, or 110_4 may generate the internal clock signal aligned with the centers of the data bits DB of the request packet PKR or the response packet PKS and may provide the internal clock signal to the first latch LC1 of the control logic CL. The first latch LC1 may latch the data bits DB of the request packet PKR and the response packet PKS in synchronization with the internal clock signal. In another example, the first latch LC1 of the control logic CL may latch the data bits DB of the request packet PKR or the response packet PKS in synchronization with the falling edges of the data strobe signal DQS.

Referring to FIGS. 4D, 4E, and 6D, the first nonvolatile memory device 110_1, the second nonvolatile memory device 110_2, the third nonvolatile memory device 110_3, and the fourth nonvolatile memory device 110_4 may align the edges of the data bits DB of the data DQ with the rising edges and the falling edges of the data strobe signal DQS. For example, based on the double data rate (DDR) scheme, the data bits DB of the data DQ may be transmitted from the first nonvolatile memory device 110_1, the second nonvolatile memory device 110_2, the third nonvolatile memory device 110_3, and the fourth nonvolatile memory device 110_4 to the memory controller 120.

The first nonvolatile memory device 110_1, the second nonvolatile memory device 110_2, the third nonvolatile memory device 110_3, and the fourth nonvolatile memory device 110_4 may align the edges of the request packet PKR and the response packet PKS with the rising edges of the data strobe signal DQS. For example, the first nonvolatile memory device 110_1, the second nonvolatile memory device 110_2, the third nonvolatile memory device 110_3, and the fourth nonvolatile memory device 110_4 may transmit the data bits DB of the request packet PKR or the response packet PKS in synchronization with the rising edges of the data strobe signal DQS. The first nonvolatile memory device 110_1, the second nonvolatile memory device 110_2, the third nonvolatile memory device 110_3, and the fourth nonvolatile memory device 110_4 may transmit the request packet PKR and the response packet PKS based on the single data rate (SDR) scheme.

For example, the delay locked loop DLL of the data buffer DTB included in the control logic CL of the nonvolatile memory device 110_1, 110_2, 110_3, or 110_4 may generate the internal clock signal aligned with the centers of the data bits DB of the request packet PKR or the response packet PKS and may provide the internal clock signal to the first latch LC1 of the control logic CL. The first latch LC1 may latch the data bits DB of the request packet PKR and the response packet PKS in synchronization with the internal clock signal. In another example, the first latch LC1 of the control logic CL may latch the data bits DB of the request packet PKR or the response packet PKS in synchronization with the falling edges of the data strobe signal DQS.

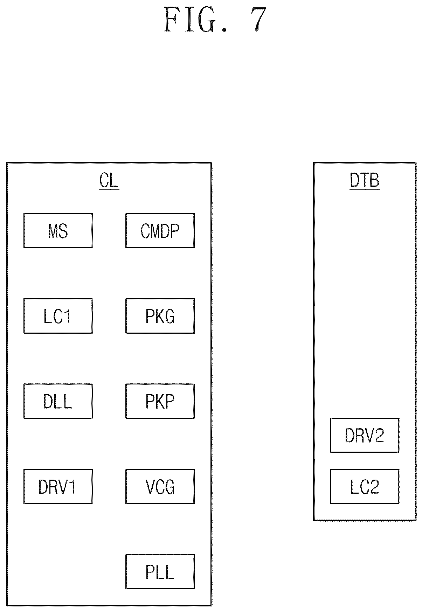

FIG. 7 illustrates a control logic CL and a data buffer DTB according to another embodiment. Referring to FIGS. 1 and 7, the control logic CL may include a mode storage MS, a first latch LC1, a delay locked loop DLL, a first driver DRV1, a command parser CMDP, a packet generator PKG, a packet parser PKP, a voltage and current generator VCG, and a phase locked loop PLL.

Configurations and operations of the mode storage MS, the first latch LC1, the delay locked loop DLL, the first driver DRV1, the command parser CMDP, the packet generator PKG, the packet parser PKP, and the voltage and current generator VCG may be similar to those of the mode storage MS, the first latch LC1, the delay locked loop DLL, the first driver DRV1, the command parser CMDP, the packet generator PKG, the packet parser PKP, and the voltage and current generator VCG, which are described with reference to FIG. 2. Thus, additional description will be omitted to avoid redundancy.

Compared to the control logic CL of FIG. 2, the control logic CL may further include the phase locked loop PLL. The control logic CL may generate a second clock signal in the inter-device communication by using the phase locked loop PLL. The first nonvolatile memory device 110_1, the second nonvolatile memory device 110_2, the third nonvolatile memory device 110_3, and the fourth nonvolatile memory device 110_4 may perform the inter-device communication by using the second clock signal without depending on the data strobe signal DQS. Accordingly, a time window in which the first nonvolatile memory device 110_1, the second nonvolatile memory device 110_2, the third nonvolatile memory device 110_3, and the fourth nonvolatile memory device 110_4 are capable of performing the inter-device communication may be extended.

The data buffer DTB may include a second driver DRV2 and a second latch LC2. Configurations and operations of the second driver DRV2 and the second latch LC2 may be similar to those of the second driver DRV2 and the second latch LC2, which are described with reference to FIG. 2. Thus, additional description will be omitted to avoid redundancy.

According to embodiments of the disclosure, the control logic CL may include the first driver DRV1 and the phase locked loop PLL for the inter-device communication. However, embodiments of the disclosure are not limited thereto. For example, the control logic CL may transfer the packet generated by the packet generator PKG to the data buffer DTB, and the second driver DRV2 of the data buffer DTB may output the packet to the first signal lines SIGL1. The output of the second driver DRV2 may be demultiplexed to be output to either the first signal lines SIGL1 or the second signal lines SIGL2. In this case, the first driver DRV1 of the control logic CL may be omitted.

In an embodiment, the memory controller 120 may access the first nonvolatile memory device 110_1, the second nonvolatile memory device 110_2, the third nonvolatile memory device 110_3, and the fourth nonvolatile memory device 110_4 in a same manner as described with reference to FIGS. 4B and 4C. Thus, additional description will be omitted to avoid redundancy.

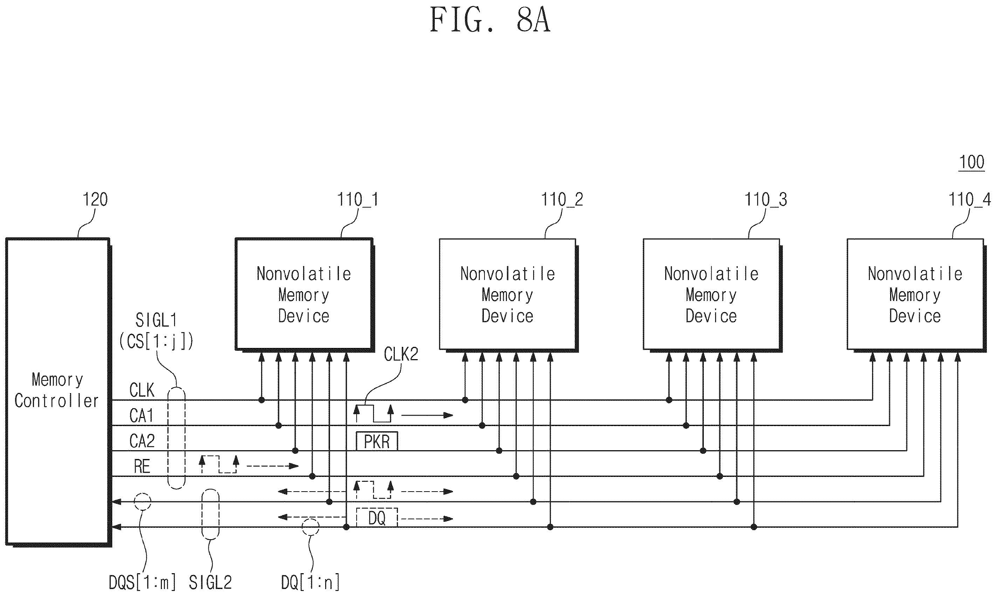

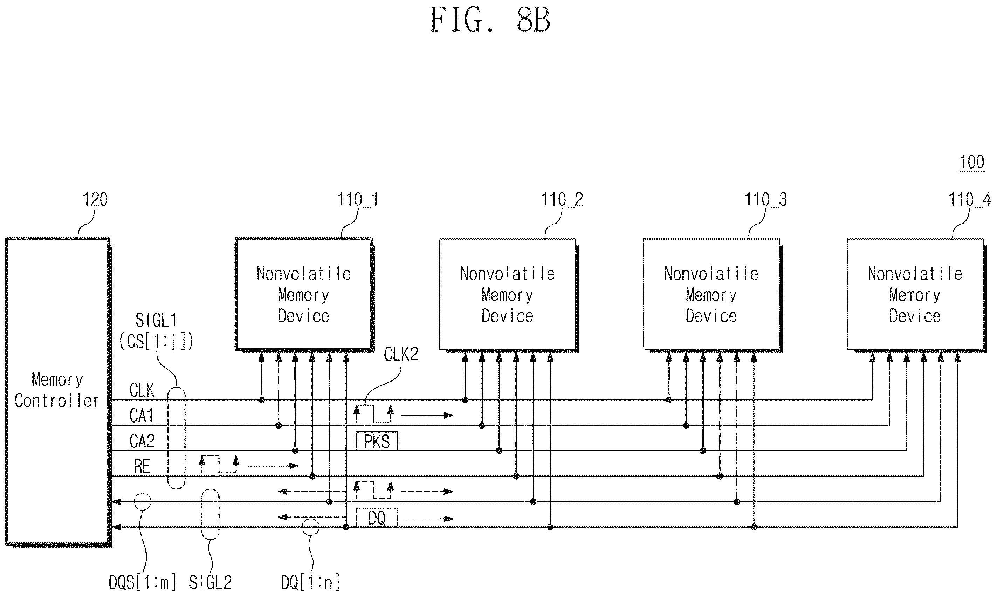

FIGS. 8A and 8B illustrate examples in which the storage device 100 operates in the SCA mode with the inter-device communication based on a second clock signal CLK2. For example, in the third mode illustrated in FIG. 3, the first nonvolatile memory device 110_1, the second nonvolatile memory device 110_2, the third nonvolatile memory device 110_3, and/or the fourth nonvolatile memory device 110_4 perform the inter-device communication based on the second clock signal CLK2 without control of the memory controller 120.

Referring to FIGS. 2 and 8A, the inter-device communication may be performed while the memory controller 120 does not output the clock signal CLK, the first command address signal CA1, and the second command address signal CA2.

In an embodiment, one of the first nonvolatile memory device 110_1, the second nonvolatile memory device 110_2, the third nonvolatile memory device 110_3, and the fourth nonvolatile memory device 110_4 may be designated as a "primary nonvolatile memory device". For example, the primary nonvolatile memory device may be determined depending on an internal policy of the memory controller 120 or depending on identification information of the first nonvolatile memory device 110_1, the second nonvolatile memory device 110_2, the third nonvolatile memory device 110_3, and the fourth nonvolatile memory device 110_4. The identification information may include, but is not limited to, serial numbers of the first nonvolatile memory device 110_1, the second nonvolatile memory device 110_2, the third nonvolatile memory device 110_3, and the fourth nonvolatile memory device 110_4. In an embodiment, the first nonvolatile memory device 110_1 may be the primary nonvolatile memory device.

In an example case in which the clock signal CLK is not received from the memory controller 120, for example, when a threshold time passes after the clock signal CLK is deactivated, the primary nonvolatile memory device 110_1 may start the inter-device communication regardless of whether the primary nonvolatile memory device 110_1 is communicating the data strobe signals DQS[1:m] with the memory controller 120. The threshold time may include, but is not limited to, a time determined in manufacturing or by the memory controller 120.

The phase locked loop PLL of the control logic CL of the primary nonvolatile memory device 110_1 may generate the second clock signal CLK2. The phase locked loop PLL may transmit the second clock signal CLK2 to a signal line transferring the first command address signal CA1 from among the first signal lines SIGL1. The second clock signal CLK2 may be transferred to the second nonvolatile memory device 110_2, the third nonvolatile memory device 110_3, the fourth nonvolatile memory device 110_4, and the memory controller 120. The memory controller 120 may ignore the second clock signal CLK2.

The packet generator PKG of the control logic CL of the primary nonvolatile memory device 110_1 may generate the request packet PKR for requesting the inter-device communication. The first driver DRV1 of the control logic CL of the primary nonvolatile memory device 110_1 may output the request packet PKR to signal lines, through which the first command address signal CA1 and the second command address signal CA2 are transferred, from among the first signal lines SIGL1 in synchronization with the second clock signal CLK2. In an embodiment, regardless of the inter-device communication, the memory controller 120 may communicate the read enable signal RE, the data signals DQ[1: m], or the data DQ with the nonvolatile memory device 110_1, 110_2, 110_3 or 110_4.

The request packet PKR may be transferred to the second nonvolatile memory device 110_2, the third nonvolatile memory device 110_3, the fourth nonvolatile memory device 110_4, and the memory controller 120. The memory controller 120 may ignore the request packet PKR.

Each of the second nonvolatile memory device 110_2, the third nonvolatile memory device 110_3, and the fourth nonvolatile memory device 110_4 may receive the request packet PKR by using the first latch LC1 of the control logic CL. For example, the first latch LC1 may latch the request packet PKR in synchronization with the second clock signal CLK2.

In an embodiment, based on the chip enable signal line corresponding to each of the second nonvolatile memory device 110_2, the third nonvolatile memory device 110_3, and the fourth nonvolatile memory device 110_4 being activated, the first latch LC1 of the control logic CL may latch the first command address signal CA1 and the second command address signal CA2 in synchronization with the clock signal CLK. Each of the second nonvolatile memory device 110_2, the third nonvolatile memory device 110_3, and the fourth nonvolatile memory device 110_4 may parse the command transmitted from the memory controller 120 by using the command parser CMDP of the control logic CL.

In an example case in which the clock signal CLK is not received, regardless of whether the data strobe signals DQS[1:m] are in an active state, the first latch LC1 of the control logic CL of the second nonvolatile memory device 110_2, the third nonvolatile memory device 110_3, and the fourth nonvolatile memory device 110_4 may latch a signal of a signal line transferring the second command address signal CA2 in synchronization with the second clock signal CLK2. Each of the second nonvolatile memory device 110_2, the third nonvolatile memory device 110_3, and the fourth nonvolatile memory device 110_4 may parse the request packet PKR transmitted from the memory controller 120 by using the packet parser PKP of the control logic CL.

In an example case in which the memory controller 120 outputs the clock signal CLK while performing the inter-device communication, the first nonvolatile memory device 110_1, the second nonvolatile memory device 110_2, the third nonvolatile memory device 110_3, and the fourth nonvolatile memory device 110_4 may be configured to stop the inter-device communication. For example, the nonvolatile memory device 110_1, 110_2, 110_3, or 110_4 may be configured to stop the inter-device communication and to complete the preparation to receive the command and address CA from the memory controller 120, before the threshold number of cycles of the clock signal CLK passes. For example, the threshold number of cycles may be set in manufacturing or may be set by the memory controller 120.

FIG. 8B illustrates an example in which the first nonvolatile memory device 110_1, the second nonvolatile memory device 110_2, the third nonvolatile memory device 110_3, and the fourth nonvolatile memory device 110_4 perform the inter-device communication based on the second clock signal CLK2 without control of the memory controller 120. In FIG. 8B, an operation which is performed following FIG. 8A is illustrated according to an embodiment. Referring to FIGS. 2 and 8B, the inter-device communication may be continued while the memory controller 120 does not output the clock signal CLK, the first command address signal CA1, and the second command address signal CA2.

In an example case in which the clock signal CLK is not received from the memory controller 120, in response to the request packet PKR, each of the second nonvolatile memory device 110_2, the third nonvolatile memory device 110_3, and the fourth nonvolatile memory device 110_4 may transmit the response packet PKS to the primary nonvolatile memory device 110_1. In an embodiment, regardless of the inter-device communication, the memory controller 120 may communicate the read enable signal RE, the data signals DQ[1: m], or the data DQ with the nonvolatile memory device 110_1, 110_2, 110_3 or 110_4.

The packet generator PKG of the control logic CL of each of the second nonvolatile memory device 110_2, the third nonvolatile memory device 110_3, and the fourth nonvolatile memory device 110_4 may generate the response packet PKS for providing device information in response to a request of the request packet PKR. The first driver DRV1 of the control logic CL of each of the second nonvolatile memory device 110_2, the third nonvolatile memory device 110_3, and the fourth nonvolatile memory device 110_4 may output the response packet PKS to a signal line, through which the second command address signal CA2 is transferred, from among the first signal lines SIGL1 in synchronization with the second clock signal CLK2 received from the primary nonvolatile memory device 110_1.

The response packet PKS may be transferred to the primary nonvolatile memory device 110_1 and the memory controller 120. The memory controller 120 may ignore the response packet PKS.

In an embodiment, the second nonvolatile memory device 110_2, the third nonvolatile memory device 110_3, and the fourth nonvolatile memory device 110_4 may sequentially output the response packet PKS. The order in which the second nonvolatile memory device 110_2, the third nonvolatile memory device 110_3, and the fourth nonvolatile memory device 110_4 output the response packet PKS may be determined by the memory controller 120, for example, based on the serial number.

The primary nonvolatile memory device 110_1 may receive the response packet PKS by using the first latch LC1 of the control logic CL. For example, the first latch LC1 may latch the response packet PKS in synchronization with the second clock signal CLK2.

In an embodiment, based on the chip enable signal corresponding to the primary nonvolatile memory device 110_1 being activated, the first latch LC1 of the control logic CL may latch the first command address signal CA1 and the second command address signal CA2 in synchronization with the clock signal CLK. The primary nonvolatile memory device 110_1 may parse the command transmitted from the memory controller 120 by using the command parser CMDP of the control logic CL.

In an example case in which the clock signal CLK is not received and based on the data strobe signals DQS[1:m] being in an active state (e.g., the data strobe signals DQS[1:m] are toggling), the first latch LC1 of the control logic CL of the primary nonvolatile memory device 110_1 may latch the first command address signal CA1 and the second command address signal CA2 in synchronization with the second clock signal CLK2. The primary nonvolatile memory device 110_1 may parse the response packet PKS transmitted from the memory controller 120 by using the packet parser PKP of the control logic CL.

According to an embodiment, based on parsing the response packet PKS, the primary nonvolatile memory device 110_1may include information of the second nonvolatile memory device 110_2, the third nonvolatile memory device 110_3, and the fourth nonvolatile memory device 110_4. The control logic CL of the primary nonvolatile memory device 110_1 may store and manage information of the primary nonvolatile memory device 110_1 together with the information of the second nonvolatile memory device 110_2, the third nonvolatile memory device 110_3, and the fourth nonvolatile memory device 110_4.

In an example case in which the memory controller 120 outputs the clock signal CLK while performing the inter-device communication, the first nonvolatile memory device 110_1, the second nonvolatile memory device 110_2, the third nonvolatile memory device 110_3, and the fourth nonvolatile memory device 110_4 may be configured to stop the inter-device communication. For example, the nonvolatile memory device 110_1, 110_2, 110_3, or 110_4 may be configured to stop the inter-device communication and to complete the preparation to receive the command and address CA from the memory controller 120, before the threshold number of cycles of the clock signal CLK (e.g., the threshold number of cycles set in manufacturing or by the memory controller 120) passes.

In an example case in which the inter-device communication is stopped, the primary nonvolatile memory device 110_1 may discard information collected during the stopped inter-device communication. In another example case in which the inter-device communication is stopped, the primary nonvolatile memory device 110_1 may store information of nonvolatile memory devices, which is completely received up to now, and may discard information of nonvolatile memory devices, which is partially received.

In an embodiment, as described in the second mode of FIG. 3, the storage device 100 may be set to the SCA mode in which the inter-device communication is not performed. In an example case in which an operation requiring a frequent access is performed, the inter-device communication may be deactivated to maximize the throughput. The operation requiring a frequent access may include, but is not limited to, a scrub operation of verifying the integrity of data stored in the storage device 100,

In another example case in which the access frequency belongs to a relatively low time period, based on a history over time or based on an access pattern of the user, the change in information of the first nonvolatile memory device 110_1, the second nonvolatile memory device 110_2, the third nonvolatile memory device 110_3, and the fourth nonvolatile memory device 110_4 may be expected as being small; in this case, the inter-device communication may be deactivated. The activation and deactivation of the inter-device communication may be determined by the memory controller 120 or the external host device communicating with the memory controller 120.

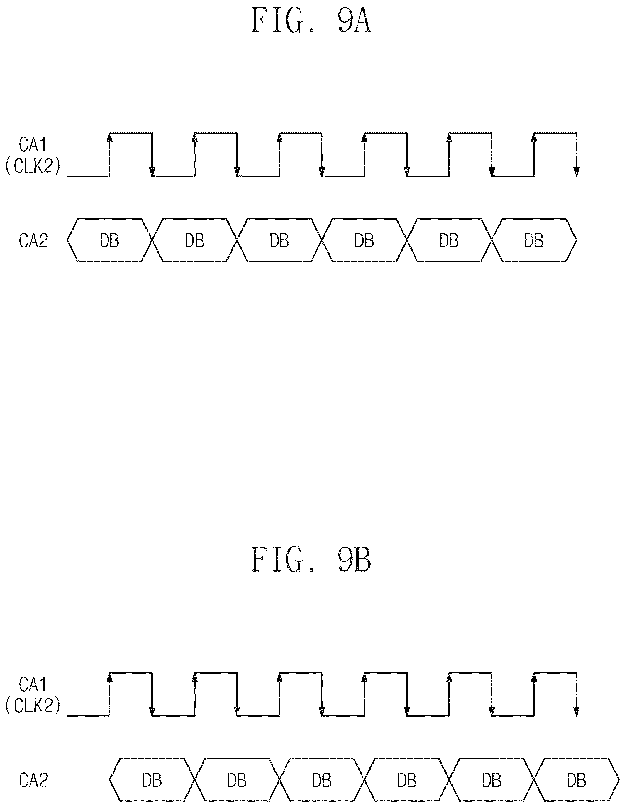

FIGS. 9A and 9B illustrate examples in which the first nonvolatile memory device 110_1, the second nonvolatile memory device 110_2, the third nonvolatile memory device 110_3, and the fourth nonvolatile memory device 110_4 communicate the first command address signal CA1 and the second command address signal CA2.

Referring to FIGS. 8A, 8B, and 9A, the primary nonvolatile memory device 110_1 may align the centers of the data bits DB, which are transmitted to a signal line transferring the second command address signal CA2, with the rising edges of the second clock signal CLK2 which is transmitted to a signal line transferring the first command address signal CA1.

Referring to FIGS. 8A, 8B, and 9B, the primary nonvolatile memory device 110_1 may align the edges of the data bits DB, which are transmitted to a signal line transferring the second command address signal CA2, with the rising edges of the second clock signal CLK2 which is transmitted to a signal line transferring the first command address signal CA1.

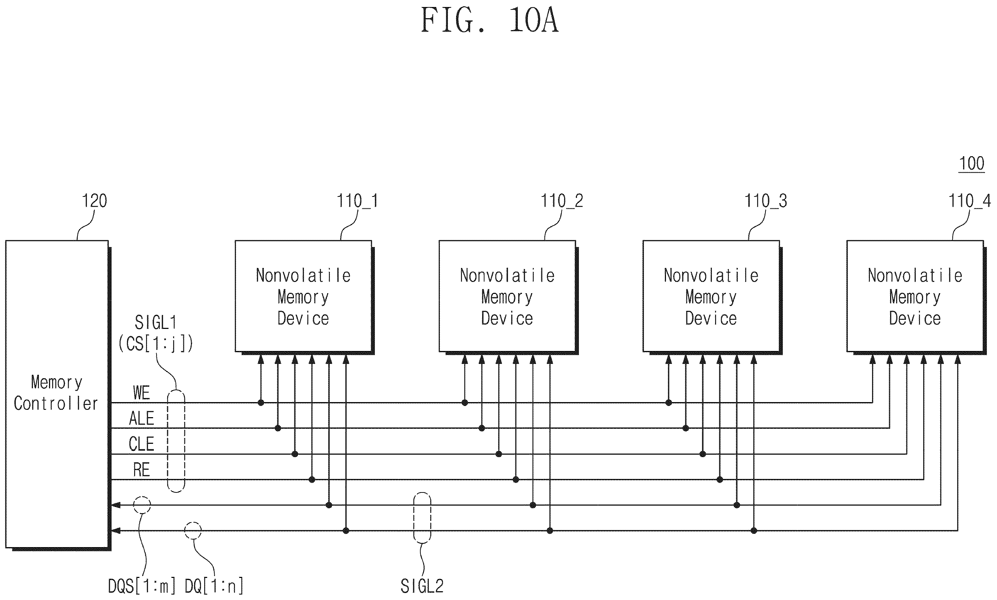

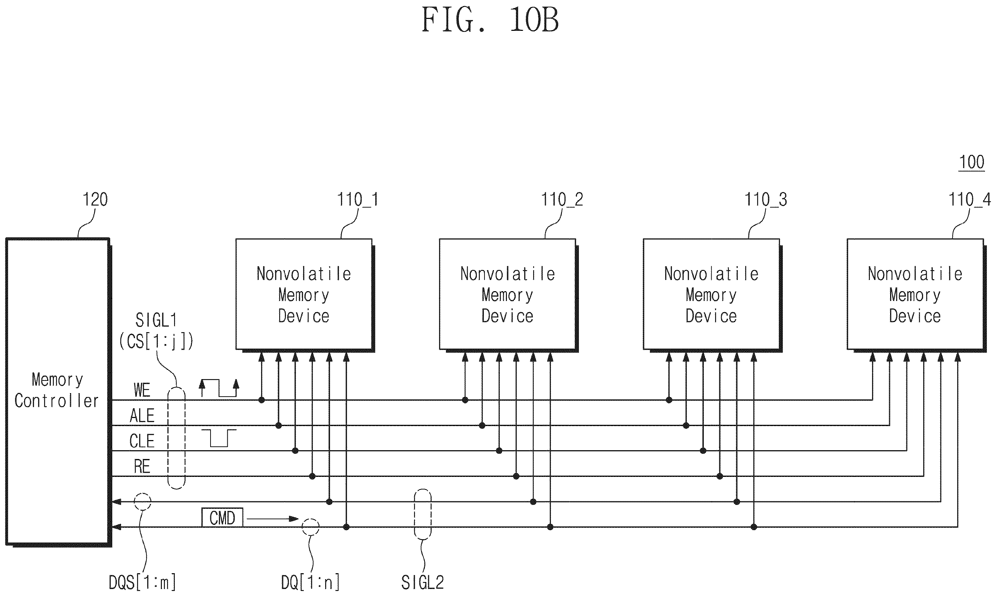

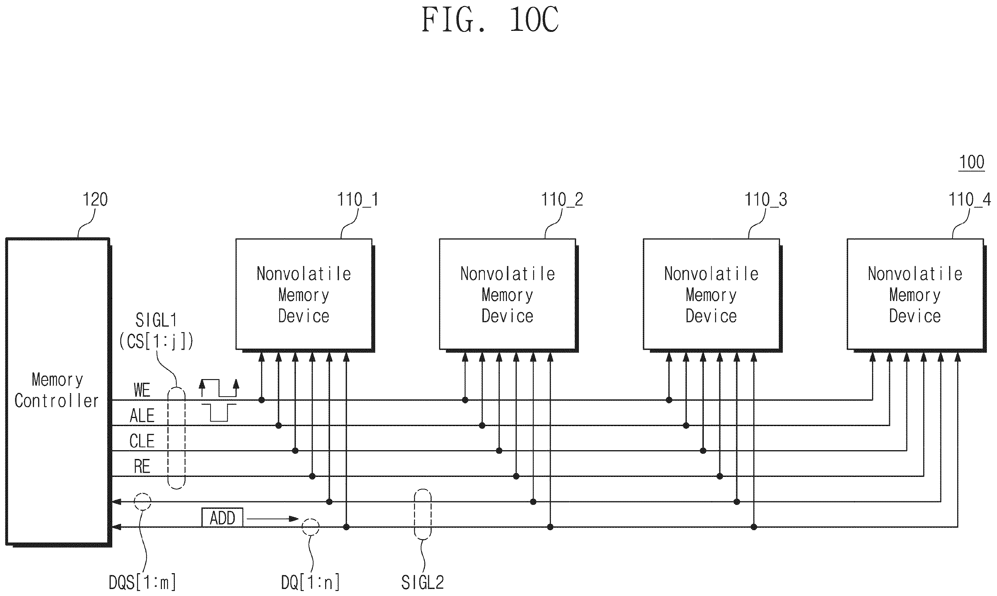

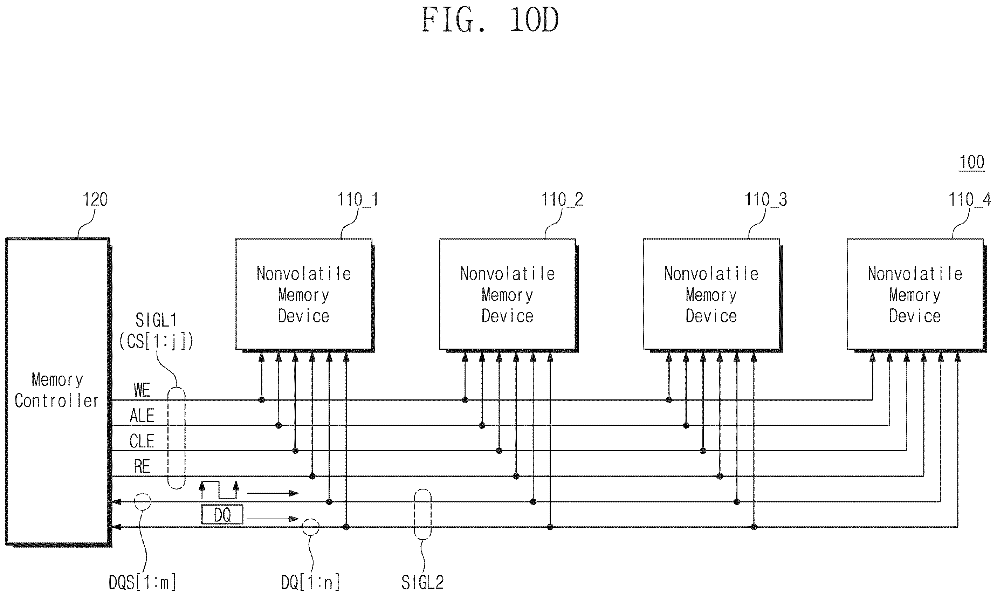

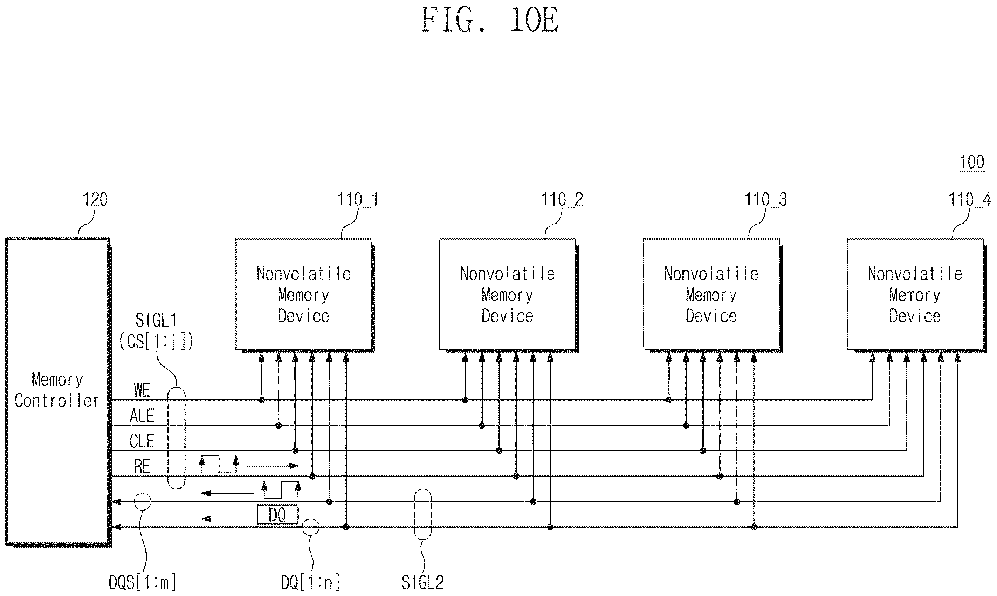

FIGS. 10A, 10B, 10C, 10D, and 10E illustrate examples in which the storage device 100 operates in the legacy mode. FIGS. 10A, 10B, 10C, 10D, and 10E illustrate an embodiment in which the first nonvolatile memory device 110_1, the second nonvolatile memory device 110_2, the third nonvolatile memory device 110_3, and the fourth nonvolatile memory device 110_4 operate in the fourth mode of FIG. 2.

Referring to FIG. 10A, the control signals CS[1:j] may include a write enable signal WE, an address latch enable signal ALE, a command latch enable signal CLE, and the read enable signal RE. The first signal lines SIGL1 may be configured to transfer the write enable signal WE, the address latch enable signal ALE, the command latch enable signal CLE, and the read enable signal RE.

FIG. 10B is a diagram illustrating an example in which the storage device 100 performs a command input operation in the legacy mode. Referring to FIGS. 2 and 10B, the memory controller 120 may toggle the write enable signal WE and may activate the command latch enable signal CLE (e.g., to a logic low level) during a given time period. During the given time period, the memory controller 120 may transmit a command CMD to signal lines transferring the data signals DQ[1:n] from among the second signal lines SIGL2 in synchronization with the write enable signal WE.

The nonvolatile memory device 110_1, 110_2, 110_3 or 110_4 activated by the chip enable signal from among the first nonvolatile memory device 110_1, the second nonvolatile memory device 110_2, the third nonvolatile memory device 110_3, and the fourth nonvolatile memory device 110_4 may receive the command CMD in synchronization with the write enable signal WE.

In an embodiment, a signal line configured to transfer the write enable signal WE in the legacy mode (or the fourth mode) may correspond to a signal line configured to transfer the clock signal CLK in the first mode, the second mode, or the third mode.

In an embodiment, a signal line configured to transfer the command latch enable signal CLE in the legacy mode (or the fourth mode) may correspond to a signal line configured to transfer the first command address signal CA1 or the second command address signal CA2 in the first mode, the second mode, or the third mode.

FIG. 10C is a diagram illustrating an example in which the storage device 100 performs an address input operation in the legacy mode. Referring to FIGS. 2 and 10C, the memory controller 120 may toggle the write enable signal WE and may activate the address latch enable signal ALE (e.g., to a logic low level) during a given time period. During the given time period, the memory controller 120 may transmit an address ADD to signal lines transferring the data signals DQ[1:n] from among the second signal lines SIGL2 in synchronization with the write enable signal WE.

The nonvolatile memory device 110_1, 110_2, 110_3 or 110_4 activated by the chip enable signal from among the first nonvolatile memory device 110_1, the second nonvolatile memory device 110_2, the third nonvolatile memory device 110_3, and the fourth nonvolatile memory device 110_4 may receive the address ADD in synchronization with the write enable signal WE.

In an embodiment, a signal line configured to transfer the address latch enable signal ALE in the legacy mode (or the fourth mode) may correspond to a signal line configured to transfer the first command address signal CA1 or the second command address signal CA2 in the first mode, the second mode, or the third mode.

FIG. 10D is a diagram illustrating an example in which the storage device 100 performs a data input operation in the legacy mode. Referring to FIGS. 2 and 10D, the memory controller 120 may toggle the data strobe signals DQS[1:m] and may transmit the data DQ in synchronization with the data strobe signals DQS[1:m].

FIG. 10E is a diagram illustrating an example in which the storage device 100 performs a data output operation in the legacy mode. Referring to FIGS. 2 and 10E, the memory controller 120 may toggle the read enable signal RE. The nonvolatile memory device 110_1, 110_2, 110_3, or 110_4 may delay the read enable signal RE to generate the data strobe signals DQS[1:m]. The nonvolatile memory device 110_1, 110_2, 110_3 or 110_4 may transmit the data DQ in synchronization with the data strobe signals DQS[1:m].

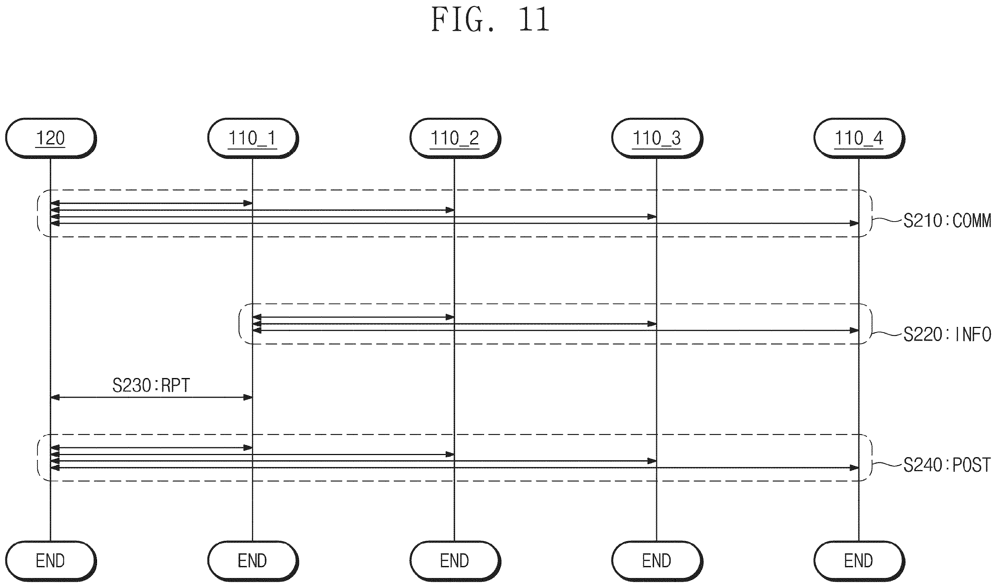

FIG. 11 illustrates an example in which the memory controller 120 uses inter-device communication. Referring to FIGS. 1 and 11, in operation S210, the memory controller 120 may perform communication COM with the first nonvolatile memory device 110_1, the second nonvolatile memory device 110_2, the third nonvolatile memory device 110_3, and the fourth nonvolatile memory device 110_4. For example, the memory controller 120 may instruct any one of the first nonvolatile memory device 110_1, the second nonvolatile memory device 110_2, the third nonvolatile memory device 110_3, and the fourth nonvolatile memory device 110_4 to perform the write operation, the read operation, or the erase operation.

In operation S220, the first nonvolatile memory device 110_1, the second nonvolatile memory device 110_2, the third nonvolatile memory device 110_3, and the fourth nonvolatile memory device 110_4 may perform the inter-device communication to exchange information INFO. For example, through the inter-device communication, the primary nonvolatile memory device 110_1 1 may collect the peak current information, the temperature information, or the status information of the first nonvolatile memory device 110_1, the second nonvolatile memory device 110_2, the third nonvolatile memory device 110_3, and the fourth nonvolatile memory device 110_4.

In operation S230, the primary nonvolatile memory device 110_1 may report the collected information to the memory controller 120 (refer to "RPT" in FIG. 11). For example, the memory controller 120 may transmit, to the primary nonvolatile memory device 110_1, a status read command requiring the information of the first nonvolatile memory device 110_1, the second nonvolatile memory device 110_2, the third nonvolatile memory device 110_3, and the fourth nonvolatile memory device 110_4. For example, based on the status read command, the primary nonvolatile memory device 110_1 may report the collected information to the memory controller 120.

In operation S240, the memory controller 120 may perform a next operation POST based on the information of the first nonvolatile memory device 110_1, the second nonvolatile memory device 110_2, the third nonvolatile memory device 110_3, and the fourth nonvolatile memory device 110_4 provided from the primary nonvolatile memory device 110_1.

For example, based on the peak current information, the memory controller 120 may perform load balancing for adjusting the access to the first nonvolatile memory device 110_1, the second nonvolatile memory device 110_2, the third nonvolatile memory device 110_3, and the fourth nonvolatile memory device 110_4.

For example, based on the temperature information, the memory controller 120 may perform thermal throttling for adjusting the access to the first nonvolatile memory device 110_1, the second nonvolatile memory device 110_2, the third nonvolatile memory device 110_3, and the fourth nonvolatile memory device 110_4.

For example, based on the status information, the memory controller 120 may again perform the access to the first nonvolatile memory device 110_1, the second nonvolatile memory device 110_2, the third nonvolatile memory device 110_3, and the fourth nonvolatile memory device 110_4 or may provide a notification message to the external host device.

As described above, the memory controller 120 may access the primary nonvolatile memory device 110_1 to collect information of all of the first nonvolatile memory device 110_1, the second nonvolatile memory device 110_2, the third nonvolatile memory device 110_3, and the fourth nonvolatile memory device 110_4. Accordingly, it may be easy for the memory controller 120 to manage the first nonvolatile memory device 110_1, the second nonvolatile memory device 110_2, the third nonvolatile memory device 110_3, and the fourth nonvolatile memory device 110_4.

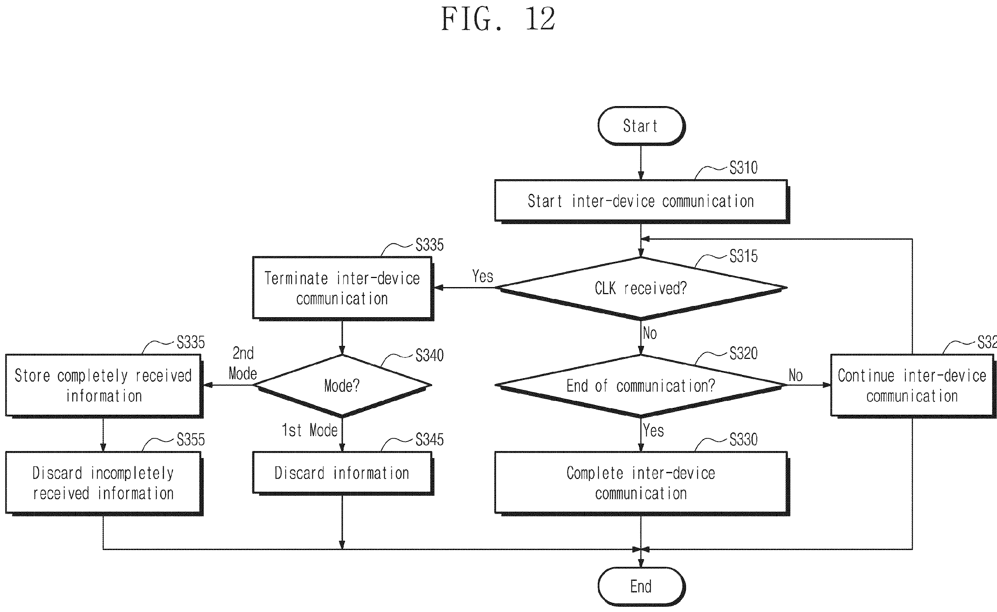

FIG. 12 is a flowchart illustrating an operating method of the nonvolatile memory device 110_1, 110_2, 110_3, or 110_4 according to an embodiment of the disclosure. Referring to FIGS. 1 and 12, in operation S310, the nonvolatile memory device 110_1, 110_2, 110_3, or 110_4 may perform the inter-device communication. As described with reference to FIGS. 1 to 11, in an example case in which the clock signal CLK or the command and address CA is not received from the memory controller 120 (or in an example case in which the clock signal CLK or the command and address CA is not received from the memory controller 120 during a threshold time), the nonvolatile memory device 110_1, 110_2, 110_3, or 110_4 may start the inter-device communication.

In operation S315, the nonvolatile memory device 110_1, 110_2, 110_3 or 110_4 may determine whether the clock signal CLK is received. For example, the nonvolatile memory device 110_1, 110_2, 110_3 or 110_4 may determine whether the clock signal CLK is received from the memory controller 120.

In an example case in which the clock signal CLK is not received, it may be expected that the command and address CA which is synchronized with the clock signal CLK is not received. In an example case in which the clock signal CLK is not received, in operation S320, the nonvolatile memory device 110_1, 110_2, 110_3 or 110_4 may determine whether the communication ends.

In an example case in which the response packet PKS is output based on (or in response to) the request packet PKR, a nonvolatile memory device (e.g., 110_2, 110_3, or 110_4) being not a primary nonvolatile memory device from among the nonvolatile memory devices 110_1, 110_2, 110_3, and 110_4 may determine the end of communication.

In an example case in which the sequential reception of the response packets PKS from secondary nonvolatile memory devices 110_2, 110_3, and 110_4 is completed based on (or in response to) the request packet PKR transmitted to the secondary nonvolatile memory devices 110_2, 110_3, and 110_4, a primary nonvolatile memory device (e.g., 110_1) among the nonvolatile memory devices 110_1, 110_2, 110_3, and 110_4 may determine the end of communication.

In an example case in which the clock signal CLK is not received (No in operation S315) and when the communication does not end (No in operation S320), in operation S325, the nonvolatile memory device 110_1, 110_2, 110_3, or 110_4 may continue the inter-device communication. That is, in operation S315, operation S320, and operation S325, the nonvolatile memory device 110_1, 110_2, 110_3, or 110_4 may perform the inter-device communication while monitoring the clock signal CLK.

In an example case in which the communication ends (Yes in operation S320), in operation S330, the nonvolatile memory device 110_1, 110_2, 110_3, or 110_4 may complete the inter-device communication. For example, the primary nonvolatile memory device 110_1 may store the information collected from the secondary nonvolatile memory devices 110_2, 110_3, and 110_4 together with the information of the primary nonvolatile memory device 110_1.

For example, the primary nonvolatile memory device 110_1 may update previously stored information such that the latest information is stored. Alternatively, the primary nonvolatile memory device 110_1 may add time stamp information such that information of two or more different times is stored.

In an example case in which the clock signal CLK is received, it may be expected that the command and address CA is received in synchronization with the clock signal CLK. In an example case in which the clock signal CLK is received, in operation S335, the nonvolatile memory device 110_1, 110_2, 110_3 or 110_4 may terminate the inter-device communication. For example, within the given number of clock cycles of the clock signal CLK (e.g., within three cycles), the nonvolatile memory device 110_1, 110_2, 110_3, or 110_4 may terminate the inter-device communication. The nonvolatile memory device 110_1, 110_2, 110_3 or 110_4 may terminate the inter-device communication regardless of whether the inter-device communication is completed.

In operation S340, different operations may be determined depending on modes of the nonvolatile memory device 110_1, 110_2, 110_3 or 110_4. In an example case in which the primary nonvolatile memory device 110_1 is in the first mode, in operation S345, the primary nonvolatile memory device 110_1 may discard information associated with the terminated inter-device communication, for example, the information collected from the secondary nonvolatile memory devices 110_2, 110_3, and 110_4.

In an example case in which the primary nonvolatile memory device 110_1 is in the second mode, in operation S335, the primary nonvolatile memory device 110_1 may store information, which is completely received, from among the information collected from the secondary nonvolatile memory devices 110_2, 110_3, and 110_4. Afterwards, in operation S355, the primary nonvolatile memory device 110_1 may discard information, which is incompletely received, from among the information collected from the secondary nonvolatile memory devices 110_2, 110_3, and 110_4.

For example, the primary nonvolatile memory device 110_1 may update previously stored information such that the latest information is stored. Alternatively, the primary nonvolatile memory device 110_1 may add time stamp information such that information of two or more different times is stored.

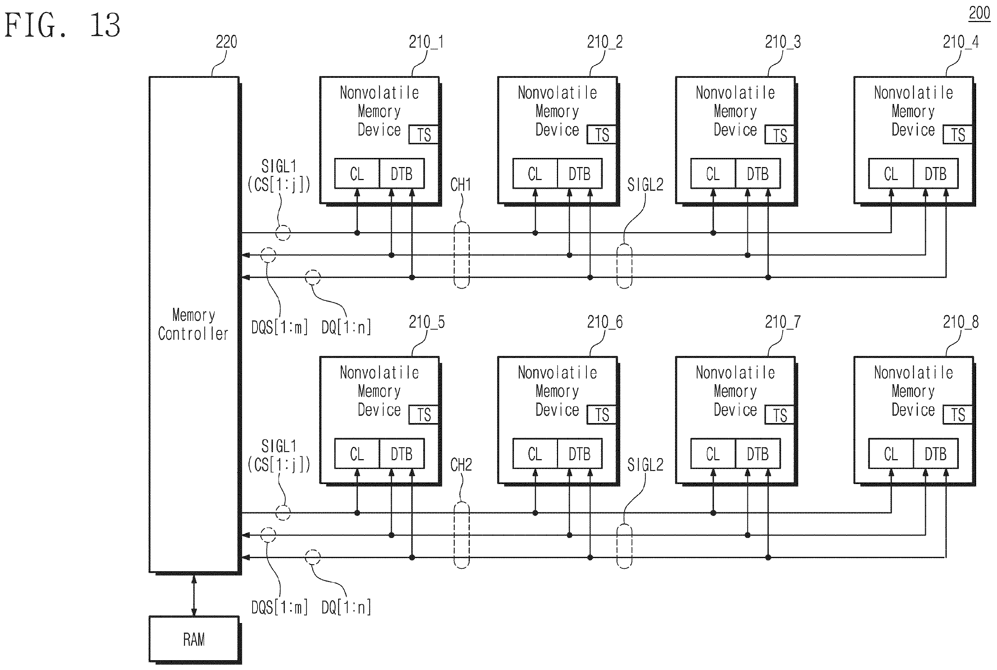

FIG. 13 illustrates a storage device 200 according to another embodiment of the disclosure. Referring to FIG. 13, the storage device 200 may include a first nonvolatile memory device 210_1, a second nonvolatile memory device 210_2, a third nonvolatile memory device 210_3, a fourth nonvolatile memory device 210_4, a fifth nonvolatile memory device 210_5, a sixth nonvolatile memory device 210_6, a seventh nonvolatile memory device 210_7, an eighth nonvolatile memory device 210_8, and a memory controller 220.

Configurations and operations of the first nonvolatile memory device 210_1, the second nonvolatile memory device 210_2, the third nonvolatile memory device 210_3, and the fourth nonvolatile memory device 210_4 may be the same as those of the first nonvolatile memory device 210_1, the second nonvolatile memory device 210_2, the third nonvolatile memory device 210_3, and the fourth nonvolatile memory device 210_4 of FIG. 1. The first nonvolatile memory device 210_1, the second nonvolatile memory device 210_2, the third nonvolatile memory device 210_3, and the fourth nonvolatile memory device 210_4 may communicate with the memory controller 220 through a first channel CH1.

Configurations and operations of the fifth nonvolatile memory device 210_5, the sixth nonvolatile memory device 210_6, the seventh nonvolatile memory device 210_7, and the eighth nonvolatile memory device 210_8 may be the same as those of the first nonvolatile memory device 210_1, the second nonvolatile memory device 210_2, the third nonvolatile memory device 210_3, and the fourth nonvolatile memory device 210_4 of FIG. 1. The fifth nonvolatile memory device 210_5, the sixth nonvolatile memory device 210_6, the seventh nonvolatile memory device 210_7, and the eighth nonvolatile memory device 210_8 may communicate to the memory controller 220 through a second channel CH2.

Each of the first channel CH1 and the second channel CH2 may include the first signal lines SIGL1 and the second signal lines SIGL2. The first signal lines SIGL1 may be configured to transfer the control signals CS[1:j]. The second signal lines SIGL2 may be configured to transfer the data strobe signals DQS[1:m] and the data signals DQ[1:n].

The memory controller 220 may independently access and independently set the first nonvolatile memory device 210_1, the second nonvolatile memory device 210_2, the third nonvolatile memory device 210_3, and the fourth nonvolatile memory device 210_4 of the first channel CH1 and the fifth nonvolatile memory device 210_5, the sixth nonvolatile memory device 210_6, the seventh nonvolatile memory device 210_7, and the eighth nonvolatile memory device 210_8 of the second channels CH2.

For example, the memory controller 220 may independently set the first nonvolatile memory device 210_1, the second nonvolatile memory device 210_2, the third nonvolatile memory device 210_3, and the fourth nonvolatile memory device 210_4 of the first channel CH1 to one of the first mode, the second mode, the third mode, and the fourth mode described with reference to FIG. 3. Regardless of the mode of the first nonvolatile memory device 210_1, the second nonvolatile memory device 210_2, the third nonvolatile memory device 210_3, and the fourth nonvolatile memory device 210_4 of the first channel CH1, the memory controller 220 may independently set the fifth nonvolatile memory device 210_5, the sixth nonvolatile memory device 210_6, the seventh nonvolatile memory device 210_7, and the eighth nonvolatile memory device 210_8 of the second channels CH2 to one of the first mode, the second mode, the third mode, and the fourth mode described with reference to FIG. 3.

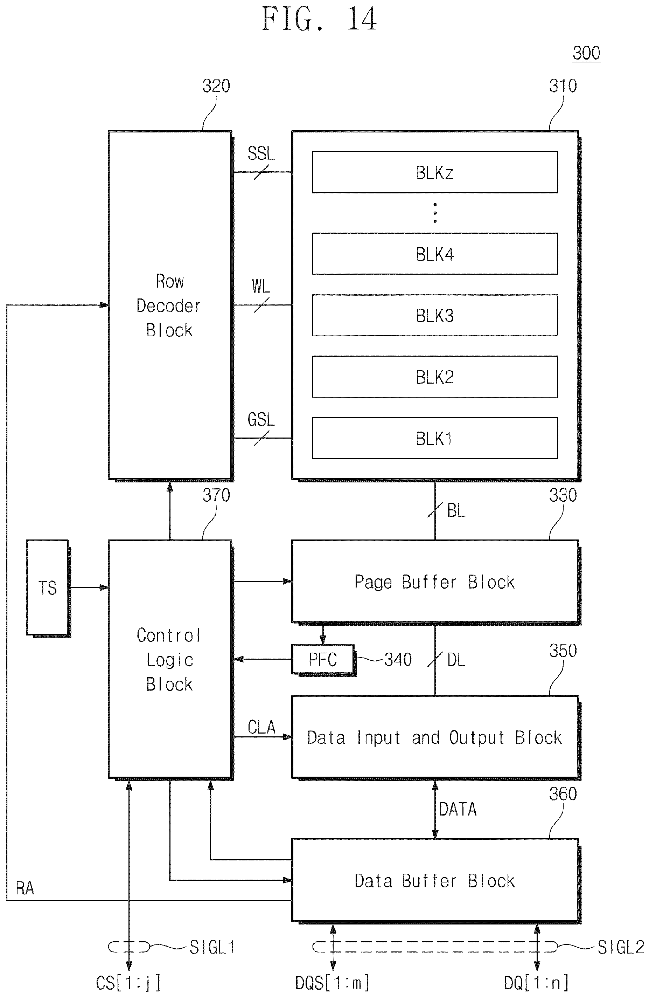

FIG. 14 is a block diagram illustrating a nonvolatile memory device 300 according to an embodiment of the disclosure. Referring to FIG. 14, the nonvolatile memory device 300 includes a memory cell array 310, a row decoder block 320, a page data buffer block 330, a pass/fail check block (PFC) 340, a data input and output block 350, a buffer data block 360, a control logic block 370, and a temperature sensor TS.

The memory cell array 310 includes a plurality of memory blocks BLK1 to BLKz. Each of the memory blocks BLK1 to BLKz includes a plurality of memory cells. Each of the memory blocks BLK1 to BLKz may be connected to the row decoder block 320 through at least one ground selection line GSL, word lines WL, and at least one string selection line SSL. Some of the word lines WL may be used as dummy word lines. Each of the memory blocks BLK1 to BLKz may be connected to the page data buffer block 330 through a plurality of bit lines BL. The plurality of memory blocks BLK1 to BLKz may be connected in common to the plurality of bit lines BL.

In an embodiment, each of the plurality of memory blocks BLK 1 to BLKz may correspond to a unit of the erase operation. Memory cells belonging to each memory block may be erased at the same time. In another example, each of the memory blocks BLK1 to BLKz may be divided into a plurality of sub-blocks. Each of the plurality of sub-blocks may correspond to a unit of the erase operation.

The row decoder block 320 is connected to the memory cell array 310 through the ground selection lines GSL, the word lines WL, and the string selection lines SSL. The row decoder block 320 operates under control of the control logic block 370.

The row decoder block 320 may decode a row address RA received from the data buffer block 360 and may control voltages to be applied to the string selection lines SSL, the word lines WL, and the ground selection lines GSL based on the decoded row address.

The page data buffer block 330 is connected to the memory cell array 310 through the plurality of bit lines BL. The page data buffer block 330 is connected to the data input and output block 350 through a plurality of data lines DL. The page data buffer block 330 operates under control of the control logic block 370.

In the program operation, the page data buffer block 330 may store data to be written in memory cells. The page data buffer block 330 may apply voltages to the plurality of bit lines BL based on the stored data. In the read operation or in the verify read operation that is performed in the program operation or the erase operation, the page data buffer block 330 may sense voltages of the bit lines BL and may store a sensing result.

In the verify read operation associated with the program operation or the erase operation, the pass/fail check block 340 may verify the sensing result of the page data buffer block 330. For example, in the verify read operation which is performed in the program operation, the pass/fail check block 340 may count the number of values (e.g., the number of 0s) corresponding to on-cells which are not programmed to a target threshold voltage or higher.

In the verify read operation which is performed in the erase operation, the pass/fail check block 340 may count the number of values (e.g., the number of 1s) corresponding to off-cells which are not erased to a target threshold voltage or lower. According to an embodiment, based on a counting result is greater than or equal to a threshold value, the pass/fail check block 340 may output a fail signal to the control logic block 370. According to an embodiment, based on the counting result is smaller than the threshold value, the pass/fail check block 340 may output a pass signal to the control logic block 370. Depending on the verification result of the pass/fail check block 340, a program loop of the program operation may be further performed, or an erase loop of the erase operation may be further performed.

The data input and output block 350 is connected to the page data buffer block 330 through the plurality of data lines DL. The data input and output block 350 may receive a column address CLA from the data buffer block 360. The data input and output block 350 may output the data read by the page data buffer block 330 to the data buffer block 360 depending on the column address CLA. The data input and output block 350 may provide the data received from the data buffer block 360 to the page data buffer block 330, based on the column address CLA.

The data buffer block 360 may communicate the data strobe signals DQS[1:m] and the data signals DQ[1:n] with the memory controller 120 or 220 through the second signal lines SIGL2. The data buffer block 360 may operate under control of the control logic block 370. The data buffer block 360 may correspond to the data buffer DTB described with reference to FIGS. 1 to 13.

The control logic block 370 may receive the control signals CS[1:j] from the memory controller 120 or 220 through the first signal lines SIGL1. The control logic block 370 may correspond to the control logic CL described with reference to FIGS. 1 to 13.

The temperature sensor TS may sense the temperature of the nonvolatile memory device 300 and may generate temperature information. The temperature sensor TS may provide the temperature information to the control logic block 370. The temperature sensor TS may be provided on a semiconductor die of the nonvolatile memory device 300.

In an embodiment, the nonvolatile memory device 300 may be manufactured in a bonding method. The memory cell array 310 may be manufactured by using a first wafer, and the row decoder block 320, the page data buffer block 330, the pass/fail check block 340, the data input and output block 350, the data buffer block 360, and the control logic block 370 may be manufactured by using a second wafer. The nonvolatile memory device 300 may be implemented by coupling the first wafer and the second wafer such that an upper surface of the first wafer and an upper surface of the second wafer face each other.

In another example, the nonvolatile memory device 300 may be manufactured in a cell over peri (COP) method. A peripheral circuit including the row decoder block 320, the page data buffer block 330, the pass/fail check block 340, the data input and output block 350, the data buffer block 360, and the control logic block 370 may be implemented on a substrate. The memory cell array 310 may be implemented over the peripheral circuit. The peripheral circuit and the memory cell array 310 may be connected by using the through vias.

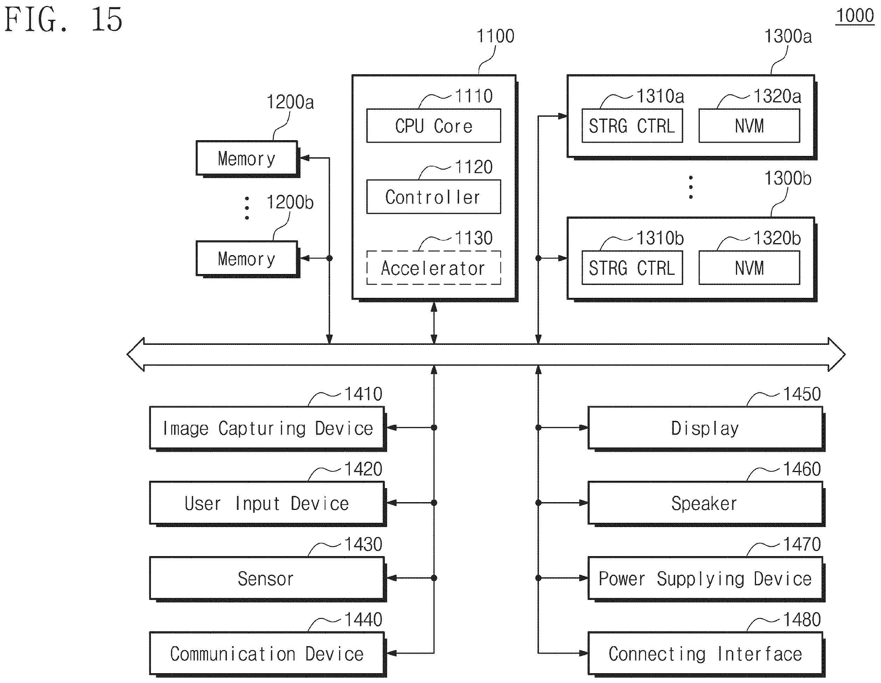

FIG. 15 is a diagram of a system 1000 to which a storage device is applied, according to an embodiment. The system 1000 of FIG. 15 may basically be a mobile system, such as a portable communication terminal (e.g., a mobile phone), a smartphone, a tablet personal computer (PC), a wearable device, a healthcare device, or an Internet of things (IOT) device. However, the system 1000 of FIG. 15 is not necessarily limited to the mobile system and may be a PC, a laptop computer, a server, a media player, or an automotive device (e.g., a navigation device).

Referring to FIG. 15, the system 1000 may include a main processor 1100, memories (e.g., 1200a and 1200b), and storage devices (e.g., 1300a and 1300b). In addition, the system 1000 may include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented as a general-purpose processor, a dedicated processor, or an application processor.

The main processor 1100 may include at least one CPU core 1110 and further include a controller 1120 configured to control the memories 1200a and 1200b and/or the storage devices 1300a and 1300b. In some embodiments, the main processor 1100 may further include an accelerator 1130, which is a dedicated circuit for a high-speed data operation, such as an artificial intelligence (AI) data operation. The accelerator 1130 may include a graphics processing unit (GPU), a neural processing unit (NPU) and/or a data processing unit (DPU) and be implemented as a chip that is physically separate from the other components of the main processor 1100.

The memories 1200a and 1200b may be used as main memory devices of the system 1000. Although each of the memories 1200a and 1200b may include a volatile memory, such as static random access memory (SRAM) and/or dynamic RAM (DRAM), each of the memories 1200a and 1200b may include non-volatile memory, such as a flash memory, phase-change RAM (PRAM) and/or resistive RAM (RRAM). The memories 1200a and 1200b may be implemented in the same package as the main processor 1100.

The storage devices 1300a and 1300b may serve as non-volatile storage devices configured to store data regardless of whether power is supplied thereto, and have larger storage capacity than the memories 1200a and 1200b. The storage devices 1300a and 1300b may respectively include storage controllers(STRG CTRL) 1310a and 1310b and NVM(Non-Volatile Memory)s 1320a and 1320b configured to store data via the control of the storage controllers 1310a and 1310b. Although the NVMs 1320a and 1320b may include flash memories having a two-dimensional (2D) structure or a three-dimensional (3D) V-NAND structure, the NVMs 1320a and 1320b may include other types of NVMs, such as PRAM and/or RRAM.

The storage devices 1300a and 1300b may be physically separated from the main processor 1100 and included in the system 1000 or implemented in the same package as the main processor 1100. In addition, the storage devices 1300a and 1300b may have types of solid-state devices (SSDs) or memory cards and be removably combined with other components of the system 100 through an interface, such as the connecting interface 1480 that will be described below. The storage devices 1300a and 1300b may be devices to which a standard protocol, such as a universal flash storage (UFS), an embedded multi-media card (eMMC), or a non-volatile memory express (NVMe), is applied,without being limited thereto.

The image capturing device 1410 may capture still images or moving images. The image capturing device 1410 may include a camera, a camcorder, and/or a webcam.

The user input device 1420 may receive various types of data input by a user of the system 1000 and include a touch pad, a keypad, a keyboard, a mouse, and/or a microphone.

The sensor 1430 may detect various types of physical quantities, which may be obtained from the outside of the system 1000, and convert the detected physical quantities into electric signals. The sensor 1430 may include a temperature sensor, a pressure sensor, an illuminance sensor, a position sensor, an acceleration sensor, a biosensor, and/or a gyroscope sensor.

The communication device 1440 may transmit and receive signals between other devices outside the system 1000 according to various communication protocols. The communication device 1440 may include an antenna, a transceiver, and/or a modem.

The display 1450 and the speaker 1460 may serve as output devices configured to respectively output visual information and auditory information to the user of the system 1000.

The power supplying device 1470 may appropriately convert power supplied from a battery (not shown) embedded in the system 1000 and/or an external power source, and supply the converted power to each of components of the system 1000.

The connecting interface 1480 may provide connection between the system 1000 and an external device, which is connected to the system 1000 and capable of transmitting and receiving data to and from the system 1000. The connecting interface 1480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and a compact flash (CF) card interface.

In an embodiment, the storage device 100 described with reference to FIGS. 1 to 14 may be implemented with the storage devices 1300a and 1300b. The nonvolatile memory NVM included in each of the storage devices 1300a and 1300b may include a plurality of nonvolatile memory devices. The plurality of nonvolatile memory devices may receive a command and address through first signal lines and may communicate data bits with the memory controller through second signal lines. While the command and the address are not received through the first signal lines, the plurality of nonvolatile memory devices may be configured to exchange information through the first signal lines without control of the memory controller.

In the above embodiments, components according to the disclosure are described by using the terms "first", "second", "third", etc. However, the terms "first", "second", "third", etc. may be used to distinguish components from each other and do not limit the disclosure. For example, the terms "first", "second", "third", etc. do not involve an order or a numerical meaning of any form.

In the above embodiments, components according to embodiments of the disclosure are referenced by using blocks. The blocks may be implemented with various hardware devices, such as an integrated circuit (IC), an application specific IC (ASIC), a field programmable gate array (FPGA), and a complex programmable logic device (CPLD), firmware driven in hardware devices, software such as an application, or a combination of a hardware device and software. Also, the blocks may include circuits implemented with semiconductor elements in an integrated circuit, or circuits enrolled as an intellectual property (IP).

According to embodiments of the disclosure, while a clock signal and a command and address synchronized with the clock signal are not received, nonvolatile memory devices may share information by using signal lines through which the command and address is transferred. Accordingly, a storage device capable of managing the nonvolatile memory devices more easily and an operating method of the storage device are provided.

While the disclosure has been described with reference to embodiments thereof, it will be apparent to those of ordinary skill in the art that various changes and modifications may be made thereto without departing from the spirit and scope of the disclosure as set forth in the following claims.

## Claims

1. A storage device (100, 200) comprising:
a plurality of nonvolatile memory devices (110_1, 110_2, 110_3, 110_4, 210_1, 210_2, 210_3, 210_4, 210_5, 210_6, 210_7, 210_8); and
a memory controller (120, 220) connected in common to the plurality of nonvolatile memory devices (110_1, 110_2, 110_3, 110_4, 210_1, 210_2, 210_3, 210_4, 210_5, 210_6, 210_7,210_8) through first signal lines (SIGL1) and connected in common to the plurality of nonvolatile memory devices (110_1, 110_2, 110_3, 110_4, 210_1, 210_2, 210_3, 210_4, 210_5, 210_6, 210_7, 210_8) through second signal lines (SIGL2),
wherein each of the plurality of nonvolatile memory devices (110_1, 110_2, 110_3, 110_4, 210_1, 210_2, 210_3, 210_4, 210_5, 210_6, 210_7, 210_8) is configured to:
based on receiving a command and an address through the first signal lines (SIGL1), communicate data bits with the memory controller through the second signal lines (SIGL2) corresponding to the command and the address received through the first signal lines (SIGL1),
based on receiving no commands through the first signal lines (SIGL1), exchange information through the first signal lines (SIGL1) with one or more other nonvolatile memory devices, among the plurality of nonvolatile memory devices (110_1, 110_2, 110_3, 110_4, 210_1, 210_2, 210_3, 210_4, 210_5, 210_6, 210_7, 210_8).

2. The storage device of claim 1, wherein the information comprises at least one of peak current information, temperature information, and status information of at respective one of the plurality of nonvolatile memory devices (110_1, 110_2, 110_3, 110_4, 210_1, 210_2, 210_3, 210_4, 210_5, 210_6, 210_7, 210_8).

3. The storage device of claim 1, wherein a first first signal line, among the first signal lines (SIGL1), is configured to transfer a clock signal (CLK) synchronized with the command and address in a first mode,
wherein, based on the clock signal (CLK) not received in the first first signal line, in a second mode, the plurality of nonvolatile memory devices (110_1, 110_2, 110_3, 110_4, 210_1, 210_2, 210_3, 210_4, 210_5, 210_6, 210_7, 210_8) are configured to exchange the information through one or more second first signal lines, among the first signal lines (SIGL1), and
wherein the one or more second first signal lines (CA1, CA2) are configured to transfer the command and the address in the first mode.

4. The storage device of claim 3, wherein at least one of the second signal lines (SIGL2) is configured to transfer a data strobe signal synchronized with the data bits, and
wherein, while the memory controller (120, 220) communicates the data bits and the data strobe signal with the plurality of nonvolatile memory devices (110_1, 110_2, 110_3, 110_4, 210_1, 210_2, 210_3, 210_4, 210_5, 210_6, 210_7, 210_8), the plurality of nonvolatile memory devices (110_1, 110_2, 110_3, 110_4, 210_1, 210_2, 210_3, 210_4, 210_5, 210_6, 210_7, 210_8) are configured to exchange the information in synchronization with the data strobe signal.

5. The storage device of claim 4, wherein a primary nonvolatile memory device among the plurality of nonvolatile memory devices (110_1, 110_2, 110_3, 110_4, 210_1, 210_2, 210_3, 210_4, 210_5, 210_6, 210_7, 210_8) is configured to transmit a packet requesting the information to one or more remaining nonvolatile memory devices among the plurality of nonvolatile memory devices (110_1, 110_2, 110_3, 110_4, 210_1, 210_2, 210_3, 210_4, 210_5, 210_6, 210_7, 210_8) through the one or more second first signal lines in synchronization with the data strobe signal.

6. The storage device of claim 5, wherein the packet comprises at least two start bits, at least two opcode bits, at least two identifier bits, at least two message bits, and at least two end bits.

7. The storage device of claim 5, wherein, based on the packet requesting the information, the one or more remaining nonvolatile memory devices are configured to respectively transmit response packets comprising the information sequentially to the primary nonvolatile memory device through the one or more second first signal lines in synchronization with the data strobe signal.

8. The storage device of claim 3, wherein the plurality of nonvolatile memory devices (110_1, 110_2, 110_3, 110_4, 210_1, 210_2, 210_3, 210_4, 210_5, 210_6, 210_7, 210_8) are configured to stop the exchange of the information based on the clock signal (CLK) being received.

9. The storage device of claim 8, wherein, based on the clock signal (CLK) being received, the plurality of nonvolatile memory devices (110_1, 110_2, 110_3, 110_4, 210_1, 210_2, 210_3, 210_4, 210_5, 210_6, 210_7, 210_8) are configured to stop the exchange of the information within a number of cycles of the clock signal from a start of the clock signal (CLK) being received.

10. The storage device of claim 8, wherein, based on the exchange of the information being stopped without completion, information under exchange is discarded.

11. The storage device of claim 8, wherein, based on the exchange of the information being stopped without completion, information of a nonvolatile memory device, which completes exchange, from among the plurality of nonvolatile memory devices (110_1, 110_2, 110_3, 110_4, 210_1, 210_2, 210_3, 210_4, 210_5, 210_6, 210_7, 210_8) is stored, and information of a nonvolatile memory device, which does not complete exchange, from among the plurality of nonvolatile memory devices (110_1, 110_2, 110_3, 110_4, 210_1, 210_2, 210_3, 210_4, 210_5, 210_6, 210_7, 210_8) is discarded.

12. The storage device of claim 3, wherein, while the clock signal (CLK) is not received, a primary nonvolatile memory device, among the plurality of nonvolatile memory devices (110_1, 110_2, 110_3, 110_4, 210_1, 210_2, 210_3, 210_4, 210_5, 210_6, 210_7, 210_8), outputs a second clock signal (CLK2) through at least one signal line among the first signal lines (SIGL1) transferring the command and address, and
wherein the nonvolatile memory devices (110_1, 110_2, 110_3, 110_4, 210_1, 210_2, 210_3, 210_4, 210_5, 210_6, 210_7, 210_8) are configured to exchange the information through at least another signal line among the one or more second first signal lines in synchronization with the second clock signal (CLK2).

13. The storage device of claim 12, wherein the primary nonvolatile memory device is configured to transmit a packet requesting the information to remaining nonvolatile memory devices among the plurality of nonvolatile memory devices (110_1, 110_2, 110_3, 110_4, 210_1, 210_2, 210_3, 210_4, 210_5, 210_6, 210_7, 210_8) through the at least another signal line in synchronization with the second clock signal (CLK2).

14. The storage device of claim 13, wherein, based on the packet requesting the information, the remaining nonvolatile memory devices are configured to respectively transmit response packets comprising the information sequentially to the primary nonvolatile memory device through the at least another signal line in synchronization with the second clock signal (CLK2).

15. The storage device of claim 1, wherein, based on a request of the memory controller (120, 220), the plurality of nonvolatile memory devices (110_1, 110_2, 110_3, 110_4, 210_1, 210_2, 210_3, 210_4, 210_5, 210_6, 210_7, 210_8) are configured to activate or deactivate the exchange of the information.
